# EUROPÄISCHE PATENTSCHRIFT

(11) **EP 1 665 911 B1**
(45) Veröffentlichungstag und Bekanntmachung des Hinweises auf die Patenterteilung: **07.05.2008**
(21) Anmeldenummer: 04761030.8
(22) Anmeldetag: 09.09.2004
(51) Int. Cl.: H05K 1/16, H05B 33/12

(54) **DÜNNSCHICHTANORDNUNG UND VERFAHREN ZUM HERSTELLEN EINER SOLCHEN DÜNNSCHICHTANORDNUNG**
THIN-FILM ASSEMBLY AND METHOD FOR PRODUCING SAID ASSEMBLY
ENSEMBLE A COUCHES MINCES ET SON PROCEDE DE PRODUCTION

(30) Priorität: 09.09.2003 AT 14152003; 24.05.2004 AT 8942004
(43) Veröffentlichungstag der Anmeldung: 07.06.2006
(73) Patentinhaber: AT & S AUSTRIA TECHNOLOGIE & SYSTEMTECHNIK Aktiengesellschaft, A-8700 Leoben-Hinterberg (AT)
(72) Erfinder: WUCHSE, Markus, A-8071 Hausmannstaetten (AT); HASLEBNER, Nikolai, A-8740 Zeltweg (AT); FROSCH, Ronald, A-8010 Graz (AT); RIEDLER, Manfred, A-8062 Kumberg (AT); LEISING, Günther, A-8042 Graz (AT)
(74) Vertreter: Weinzinger, Arnulf
(86) Internationale Anmeldenummer: PCT/AT2004/000308
(87) Internationale Veröffentlichungsnummer: WO 2005/025282

(56) Entgegenhaltungen:
- EP-A- 0 854 662
- DE-A- 19 715 658
- US-A- 4 594 282
- US-A- 4 839 558
- US-A1- 2002 039 000

## Beschreibung

Die Erfindung betrifft eine Anordnung sowie ein Verfahren gemäß den einleitenden Teilen der unabhängigen Ansprüche 1 und 33.

Aus der US 4 839 558 A ist eine Anordnung mit Elektrolumineszenz-Elementen auf einem Substrat bekannt, welches als Leiterplatte vorliegen und andere Elektronikkomponenten tragen kann. Die bekannte Elektrolumineszenz-Anordnung ist dabei als Dickschichtstruktur auf dem Substrat aufgebracht, wobei die elektrolumineszierende Schicht auf nach einem Ätzen verbleibenden Kupferkaschierungs-Grundelektroden aufgedruckt wird. Darüber wird eine durchsichtige Abdeckung aus Glas mit einer inneren Zinnoxidschicht als Elektrode mit Hilfe eines Adhäsivs angebracht. Eine derartige Struktur hat nicht nur den Nachteil von vergleichsweise großen Abmessungen, insbesondere in Dickenrichtung, sondern auch jenen einer aufwendigen Herstellung.

In der DE 197 15 658 A ist eine Multifunktions-Leiterplatte mit optoelektronisch aktiven Bauelement beschrieben, welches in Form eines in die Leiterplatte integrierten Leuchtfeldes ausgebildet ist. Zur Herstellung dieser Dickschicht-EL-Anordnung wird Siebdruck verwendet, wobei die Elektrolumineszenzschicht unter Zwischenlage einer Isolierschicht auf der strukturierten Leiterschicht der Leiterplatte aufgebracht wird.

Aus der EP 1 087 649 A ist es bekannt, eine Elektrolumineszenz-Anordnung in Dünnschichttechnik auf einem Substrat und innerhalb einer verkapselung anzubringen, wobei als aktive Schicht für die Elektrolumineszenz insbesondere eine organische (oder aber auch anorganische) Licht emittierende Schicht angebracht wird. Unterhalb hiervon wird auf dem Substrat eine Grundelektrode beispielsweise durch Niederschlagen aus der Dampfphase angebracht, und über der Licht emittierenden Schicht wird in ähnlicher Weise ein leitendes Material aus der Dampfphase niedergeschlagen, um eine Deckelektrode zu bilden. In Hinblick auf eine matrixartige Anordnung von Elektrolumineszenz-Elementen, für ein Display, werden die Deckelektroden dabei in Zeilenform und die Grundelektroden in Spaltenform angebracht, wogegen die aktiven Elektrolumineszenz-Elemente "punktweise" vorliegen. In Hinblick auf die Dünnschichttechnik, die hier zur Realisierung der Elektrolumineszenz-Anordnung angewandt wird, wird ein Glassubstrat verwendet, welches mit einer ausreichend glatten Oberfläche vorliegen kann, um die einzelnen Dünnschichten problemlos anbringen zu können, wobei überdies auch die erforderliche Inert-Eigenschaft gegeben ist, d.h. aus dem Glasmaterial diffundieren keine Substanzen in den jeweiligen Dünnschichtaufbau. Ein derartiges Glassubstrat hat jedoch den Nachteil, dass es verhältnismäßig aufwendig und teuer in der Herstellung ist, und dass es sich weniger gut zur Montage weiterer elektronischer Bauelemente, insbesondere im Zuge einer miniaturisierten Schaltungsanordnung, eignet.

Andererseits ist eine klassische Leiterplatte mit einer metallischen Kaschierung, insbesondere Kupferkaschierung, auf einem isolierenden bzw. dielektrischen Grundkörper nicht mit Dünnschichttechniken kompatibel.

Es ist nun Aufgabe der Erfindung, hier Abhilfe zu schaffen und eine Technik vorzusehen, mit der in einfacher und preiswerter Weise Dünnschichtanordnungen ermöglicht werden, ohne dass für diese aufwendige Substrate aus Glas benötigt werden. Insbesondere wird mit der Erfindung angestrebt, an sich herkömmliche Leiterplatten einsetzen zu können und in diesen direkt die gewünschten elektronischen Dünnschichtbauelemente, wie insbesondere Elektrolumineszenz-Anordnungen, aber auch andere elektronische Bauelemente, zu integrieren, wobei selbstverständlich zusätzlich auch eine Bestückung mit elektrischen Bauelementen in herkömmlicher Weise möglich sein soll.

Zur Lösung dieser Aufgabe sieht die Erfindung eine Anordnung wie in Anspruch 1 gekennzeichnet bzw. ein Verfahren wie in Anspruch 33 definiert vor. Vorteilhafte Ausführungsformen und Weiterbildungen sind in den abhängigen Ansprüchen angegeben.

Gemäß der Erfindung wird somit eine herkömmliche Leiterplatte "konditioniert", um sie mit Dünnschichtsystemen kompatibel zu gestalten. Dabei wird zur Bildung der Grundelektrode die Leiterschicht, also die Metallkaschierung der Leiterplatte, geglättet bzw. poliert, um so eine Basis für einen Dünnschichtaufbau zu schaffen. Die so erhaltene Grundelektrode kann im Bedarfsfall noch chemisch bzw. elektrochemisch verstärkt werden, wobei dann die angesprochene Glättung der Oberfläche der Grundelektrode nach Anbringung einer solchen Verstärkung erfolgt. Die Glättung führt dabei zu einer mittleren Oberflächenrauigkeit von maximal 10 nm, bevorzugt maximal 3 nm, wobei sich die entsprechende Rauigkeitsbestimmung auf technologisch relevante Flächen der Größe 20 x 20 µm² (Mikrorauigkeit) beschränkt. Unebenheiten größerer lateraler Ausdehnung (Makrorauigkeit) sind in Dünnschicht-technologischer Hinsicht irrelevant. Auf der so erhaltenen mikroskopisch glatten Oberfläche der Grundelektrode ist dann eine Kontaktschicht vorhanden, die bevorzugt metallisch ist, aber auch eine sonstige anorganische oder organische chemische Schicht oder auch Halbleiterschicht sein kann, und die insbesondere mehrere Funktionen erfüllen kann: Zum Einen dient diese Kontaktschicht zur Passivierung der Metallkaschierung (Grundelektrode), so dass keine Substanzen aus der Metallkaschierung in den darüber befindlichen Dünnschichtaufbau, z.B. mit organischen Elektrolumineszenzschichten, diffundieren können. Insbesondere ist die Kontaktschicht zum Anderen eine Kontakt-"Vermittlungs"-Schicht, die den elektrischen Kontakt zwischen den aktiven oder passiven Dünnschichten des Dünnschichtbauelements und der Grundelektrode verbessert und stabilisiert. Weiters ist diese Kontaktschicht auch eine Haftverbesserungsschicht, die die Haftung der Dünnschichtstruktur auf der Grundelektrode stabilisiert und so eine Langzeit-Haftung sicherstellt. Die jeweilige Kontaktschicht ist naturgemäß abhängig vom jeweils zu integrierenden Dünnschichtbauelement zu wählen, und sie wird im Allgemeinen fotolithografisch strukturiert und mittels üblicher Dünnschichtverfahren, also durch thermisches Verdampfen, durch Kaltkatodenbeschichtung, durch Schleuderbeschichtung usw., aufgebracht. Die Kontaktschicht besteht beispielsweise aus einem Metall, wie insbesondere aus Aluminium, Gold, Palladium oder Platin etc., es können jedoch zur Bildung der Kontaktschicht auch leitfähige Suspensionen und Lösungen, z.B. Polyanilin, Polyethylen-Dioxithiophen/Polystyrolsulfonsäure usw., eingesetzt werden. Durch die Glättung der die Grundelektrode bildenden Leiterschicht sowie die Anbringung der Kontaktschicht wird eine gute Adhäsion der jeweiligen Dünnschichtstruktur sowie ein adäquater elektrischer Kontakt gesichert, so dass es möglich ist, Dünnschichtstrukturen an herkömmlichen Leiterplatten mit dielektrischem Grundkörper und Metallkaschierung zu integrieren. Die Leiterplatten können dabei, wie derzeit zumeist im Einsatz, aus einem Epoxidharz-Grundkörper mit einer doppelseitigen Kupferkaschierung bestehen. Die Kupferkaschierung oder allgemein Metallkaschierung ist an sich vergleichsweise dick und kann mit Vorteil auch als Kühlelement für die jeweilige Dünnfilmstruktur dienen; für diese Kühlfunktion kann die Kupferkaschierung auch entsprechend dick gewählt (oder verstärkt) werden. Es ist aber selbstverständlich auch möglich, flexible Leiterplatten, auch "Leiterbahnfolien" genannt, zu verwenden, die z.B. einen Isoliermaterial-Grundkörper aus Polyimid, Polyethylennaphthalat oder Polyester aufweisen, wobei wiederum eine Metallkaschierung, z.B. aus Kupfer, als Leiterschicht vorgesehen sein kann.

Es sei erwähnt, dass der vorerwähnte Begriff "elektronisch" hier in einem breiten Sinn zu verstehen ist und insbesondere auch elektro-optische Systeme bzw. Schichten mit umfassen soll, wie insbesondere Elektrolumineszenz-Anordnungen, wie sie an sich bekannt sind, vgl. außer den eingangs erwähnten Dokumenten us 4 839 558 A, DE 197 15 658 A und EP 1 087 649 A auch die EP 0 854 662 A. In vergleichbarer Weise sind als "elektronische" Dünnschichtbauelemente mit der erfindungsgemäßen Technik aber auch beispielsweise Solarzellen, Sensoren, und zwar insbesondere optische Sensoren, aber auch Temperatursensoren und dgl., und weiters derartige elektronische Bauelemente wie Dioden, Transistoren, Feldeffekttransistoren, Leuchtdioden, Widerstände, Kondensatoren und Schutzelemente (z.B. Überspannurigsschutzelemente) denkbar. Diese Dünnschichtbauelemente können jeweils wie an sich bekannt durch eine Verkapselung gegen Umgebungseinflüsse geschützt sein, wobei es weiters insbesondere auch möglich ist, innerhalb der Verkapselung, die ein freies, mit Gas gefülltes Volumen umschließt, Gettermaterialien einzubauen, die Sauerstoff und/oder Wasser im Gasvolumen aufnehmen und so das Dünnschichtbauelement gegen unerwünschte chemische Prozesse schützen. Im Falle einer Elektrolumineszenz-Anordnung oder einer fotovoltaischen-Anordnung, aber auch eines optischen Sensors als Dünnschichtbauelement, ist die Verkapselung durchscheinend oder durchsichtig ausgebildet, ebenso wie die Deckelektrode und eine gegebenenfalls unter dieser vorhandene eigene Kontaktschicht, die wieder - zusätzlich - zur Kontaktvermittlung, Stabilisierung und Passivierung vorgesehen sein kann.

Im Fall einer Elektrolumineszenz-Anordnung kann die Verkapselung in an sich bekannter Weise mit Farbwandler- bzw. Indexanpassungsschichten ausgerüstet sein, die zu den lokalen Grundelektroden bzw. lokalen Dünnschichtbauelementen ausgerichtet sind.

In Hinblick auf den erfindungsgemäß in vorteilhafter Weise ermöglichten Einsatz einer herkömmlichen Leiterplatte als Substrat und die damit gegebenen Möglichkeiten für das Vorsehen der verschiedensten Muster von lokalen Grundelektroden ist es im Fall einer Elektrolumineszenz-Vorrichtung als Dünnschichtbauelement-System von besonderem Vorteil, wenn lokale Grundelektroden, die individuelle Durchkontaktierungen haben, innerhalb einer isolierenden Gitterstruktur auf der Leiterplatte vorliegen und darüber ein flächiges Elektrolumineszenz-Dünnschichtsystem sowie eine flächige oder aber streifen- oder symbolweise strukturierte Deckelektrode angebracht sind. Bei einer solchen Ausbildung kann die jeweilige Dünnschichtstruktur samt Deckelektrode in besonders einfacher Weise integriert werden, ohne dabei an Steuerungsmöglichkeiten für die einzelnen Elektrolumineszenz-Elemente einzubüßen.

Ein weiterer Vorteil der Verwendung einer herkömmlichen Leiterplatte besteht auch darin, dass zur Kontaktierung der Elektroden durch den Leiterplatten-Grundkörper hindurch an sich bekannte sog. Via-Verbindungen vorgesehen werden können. Diese Durchkontaktierungen, insbesondere lasergebohrte Durchkontaktierungen, ergeben wegen ihrer engen, miniaturisierten Anbringung die Möglichkeit einer Integration von Bauelementen, insbesondere optoelektronischen Bauelementen, mit besonders hoher Dichte, so dass beispielsweise Anzeigesysteme mit einer Vielzahl von kleinen, nahe aneinander angebrachten Bildpunkten, d.h. hoch auflösende Anzeigesysteme, erzielt werden können. Denkbar sind aber auch Durchkontaktierungen auf Basis mechanischer Bohrungen oder Plasma-geäzte Verbindungen. Mit Vorteil sind die Durchkontaktierungen zum Anschluss der Grundelektroden direkt unter diesen Grundelektroden vorgesehen; man spricht in diesem Fall von einer sog. Via-In-Electrode(VIE)-Struktur. Es ist aber auch möglich und im Hinblick auf die Kontaktierung der Deckelektroden üblich, Durchkontaktierungen versetzt zu den zugehörigen Elektroden zu positionieren, wobei dann eine horizontale elektrische Verbindung von einem Via-Pad an der Oberseite der Leiterplatte zum Bauelement herzustellen ist. Eine derartige Struktur wird Via-Off-Electrode(VOE)-Struktur genannt.

Bei Anbringung mehrerer Dünnschichtbauelemente auf der Leiterplatte, wie dies in der Regel der Fall sein wird, sind die Bereiche auf der Metallkaschierung der Leiterplatte zwischen den Dünnschichtbauelementen zu entfernen, wobei auch eine zusätzliche Isolierung, beispielsweise aus einem Fotolack, hergestellt und in einem Fotolithografieverfahren lateral strukturiert angebracht wird. Diese Isolierungen umschließen die einzelnen Dünnschichtbauelemente einschließlich ihrer Grundelektroden und isolieren sie so gegeneinander. Dabei ist es auch hier vor Anbringung der Isolierungen zweckmäßig, die von der Metallkaschierung bzw. Leiterschicht freigelegten Bereiche der Leiterplatte durch eine Passivierungsschicht, die mit Hilfe einer herkömmlichen Dünnschichttechnik angebracht wird, zu "verschließen" und so eine Kontamination des jeweiligen Dünnschichtbauelements durch aus dem Grundkörper der Leiterplatte austretende Substanzen zu verhindern. Diese Passivierungsschicht kann beispielsweise aus Siliziumoxid, aus einem Sol-Gel-System oder einer Epoxidverbindung bestehen. Auch hier ist selbstverständlich die jeweilige Passivierungsschicht wieder in Abhängigkeit von der Art der übrigen Materialien, insbesondere des Materials des Grundkörpers der Leiterplatte, auszuwählen, und die Passivierungsschicht wird in der Regel fotolithografisch strukturiert und mittels üblicher Dünnschichtverfahren, wie etwa durch thermisches Verdampfen, durch Schleuderbeschichtung, durch Tintendruckprozesse oder durch Kaltkatodenbeschichtung etc., aufgebracht. Anstatt einer solchen strukturierten, lokalen Aufbringung ist aber auch eine zunächst vollflächige, gleichförmige Aufbringung einer Passivierungsschicht, etwa als Laminat, denkbar, wobei nachträglich eine Strukturierung mit Hilfe fotolithografischer Ätztechniken durchgeführt wird.

Wie vorstehend erwähnt ist ein wesentliches Merkmal für die Einsatzmöglichkeit von herkömmlichen Leiterplatten bei den vorliegenden Dünnschichtanordnungen darin zu sehen, dass die Leiterschicht bzw. lokale Grundelektroden, die aus dieser Leiterschicht durch Strukturieren erhalten wurden, zwecks Erzielung einer geringen Oberflächenrauigkeit geglättet werden. Dieses Glätten kann auf vielfältige, an sich übliche Weisen realisiert werden, wobei mechanische, aber auch elektrochemische, chemische und chemisch-mechanische Glättungsverfahren und/oder ein Polieren durch Ionenätzen sowie eine Kombination dieser Verfahren möglich sind. Insbesondere ist es hier denkbar, dass die Leiterschicht durch chemisches Ätzen, beispielsweise mit Schwefelsäure, Salpetersäure oder Chromschwefelsäure, geglättet wird. Andererseits ist es auch vorteilhaft, wenn die Leiterschicht durch Beschuss mit Partikeln einzelner oder mehrerer Atome oder Moleküle, wie z.B. Argon oder Argon-Cluster, geglättet wird.

Im Fall der Anbringung einer Verstärkung der lokalen Grundelektroden ist es weiters zweckmäßig, die Leiterplatte zuvor in den übrigen Bereichen vorübergehend fotolithografisch zu passivieren. Die hierfür angebrachte Passivierungsschicht wird nachfolgend, noch vor Anbringen der jeweiligen Dünnschichtbauelemente, insbesondere noch vor Anbringen der Kontaktschichten, wieder entfernt.

Im Falle einer Strukturierung der Leiterschicht zur Bildung lokaler Grundelektroden ist es im Übrigen auch denkbar, eine Glättung der Leiterschicht noch vor der (insbesondere fotolithografischen) Strukturierung der Leiterschicht durchzuführen.

Wie bereits vorstehend erwähnt können im Rahmen der erfindungsgemäßen Technik nicht nur starre Leiterplatten, sondern auch flexible Leiterplatten Anwendung finden. Derzeit werden solche flexible Leiterplatten beispielsweise als mechanisch robuste und platzsparende Verbindungstechnik in vielfältiger Form, etwa als "Flachbandkabel-Ersatz", eingesetzt, wobei sie nicht nur bewegliche Verbindungen zwischen einzelnen elektrischen Komponenten eines Geräts ermöglichen, sondern auch durch Biegen, Falten und Verwinden eine optimierte Anordnung der Leiterplatte im zur Verfügung stehenden Innenraum eines Gehäuses erlauben. Die Integration von Dünnschichtbauelementen auf derartigen flexiblen Leiterplatten gemäß der hier beschriebenen Technik bietet nun die Möglichkeit, den flexiblen Bereich durch Integration passiver bzw. aktiver Dünnschichtbauelement zu nutzen, ohne dass dies zu einer Versteifung der Leiterplatte - wie etwa im Fall von konventionellen starren, dicken Bauelemeten - führen würde. Damit können bewegliche, biegsame und mechanisch robuste Komponenten realisiert werden, und die Leiterplatte wird so wie das Dünnschichtbauelement selbst aufgrund des geringen Volumens und der geringen Masse der Dünnschichtkomponenten im Fall einer mechischen Belastung in einem wesentlich geringeren Maße beansprucht. Der Einsatz von flexiblen Leiterplatten und in der Folge von flexiblen Dünnschichtanordnungen ist für viele Anwendungen denkbar, wie etwa bei mechanisch besonders belastbaren elastischen Elektronikkomponenten, die Erschütterungen, Beschleunigungen usw. ausgesetzt sind, bei Bauelementen, deren Flexibilität Teil ihrer Funktionalität ist, wie etwa im Fall von Tastaturen oder Sensoren, bei "bestückten" faltbaren Leiterplatten bis hin zu biegsamen oder gar aufrollbaren Bildschirmen.

Auch im Fall von derartigen flexiblen Leiterplatten wird wie vorstehend ausgeführt die Leiterschicht "konditioniert", um sie mit dem jeweiligen Dünnschichtsystem kompatibel zu machen. Es wird also die Leiterschicht, welche die Grundelektrode des Dünnschichtbauelements bildet, geglättet bzw. poliert und gegebenenfalls verstärkt; weiters wird die Grundelektrode mit einer Bauelement-adäquaten Kontaktschicht versehen, welche mit Hilfe eines üblichen Dünnschichtverfahrens, also beispielsweise durch thermisches Verdampfen, durch Kaltkathodenbeschichtung, durch Schleuderbeschichtung usw., aufgebracht werden kann. Grundsätzlich sind im Übrigen sämtliche Dünnschichtverfahren in hervorragender Weise geeignet, flexible Substrate zu beschichten und dabei flexible Strukturen zu bilden, wobei gegebenenfalls Adaptionen im Verfahrensablauf, vor allen Dingen für den Transport der Substrate zwischen einzelnen Prozessstationen, vorzusehen sind. Es bedarf somit keiner Modifikation des Aufbaus des jeweiligen Dünnschichtbauelements, wenn anstatt einer starren Leiterplatte eine flexible Leiterplatte zum Einsatz kommt, und gerade Dünnschichttechniken erlauben eine Ausweitung des Anwendungsspektrums zufolge der Verwendung von flexiblen Leiterplatten bis hin zu aktiven flexiblen Flächengebilden, wobei insgesamt flexible und ultraleichte Dünnschichtanordnungen mit geringsten Ausdehnungen der Bauelemente hergestellt werden können, die starken mechanischen Beanspruchungen, wie Erschütterungen und hohe Beschleunigungen bzw. Verzögerungen, im Weitaus höherem Maß gewachsen sind als vergleichsweise deutlich dickere und schwerere konventionelle Bauelemente. Es können sogar bestückte, faltbare oder aufrollbare Leiterplatten, d.h. Dünnschichtanordnungen, erhalten werden, die eine optimale räumliche Anpassung der Elektronik-Komponenten an das jeweilige Gerät und Gehäuse erlauben. Dabei ist auch eine flexible Passivierung bzw. flexible Verkapselung unproblematisch. Beispielsweise können anstatt einer Verklebung mit starren Gläsern dünne Glaslaminate oder Polymer-Oxid-Verbundschichtsysteme verwendet werden, welche trotz ihrer geringen Dicke einen ausreichenden Schutz gegenüber Eindringen von Gasen oder Feuchte bieten und somit eine Kontamination der jeweiligen Dünnschichtbauelemente wirksam verhindern. Bei geeigneter Wahl und Ausführung des Verkapselungsmaterials in Relation zum flexiblen Leiterplatten-Substrat kann auch eine Anordnung des integrierten Dünnschichtbauelementes genau in der neutralen Ebene der gesamten Anordnung erreicht werden, so dass im Fall einer Biegung des Gesamtsystems im Dünnschichtbauelement selbst, d.h. im Bereich der Grenzschicht: Leiterplatte/Verkapselung wenn überhaupt so nur geringe Zug- und Druckkräfte auftreten.

Die flexible Verkapselungsschicht kann gegebenenfalls vorgefertigt und auf der Leiterplatte angebracht werden, wobei dann beispielsweise eine Adhäsionslage als Haftvermittlungs-Zwischenschicht sowie eine Passivierungslage als Sperrschicht für Feuchte und Luft vorgesehen werden können. Die Verkapselungsschicht kann gegebenenfalls aber auch als Verbundsystem direkt über dem Dünnschichtbauelement aufgebaut werden.

Im Fall von optoelektronisch aktiven Dünnschichtbauelementen bzw. Anzeigesystemen wird auch hier die (flexible) Verkapselung zweckmäßig transparent bzw. transluzent, es kann aber auch die flexible Leiterplatte transparent bzw. transluzent ausgebildet werden, beispielsweise durch Verwendung von Polyethylenterephthalat Polyacryl; oder Polyetherethereketon, wobei diese Basismaterialien mit transparenten bzw. semitransparenten Metallfilmen, Metalllegierungen, leitfähigen Metalloxiden (z.B. Aluminium-dotiertes Zinkoxid, Zinn-dotiertes Indiumoxid usw.), und/oder leitfähigen Suspensionen oder Lösungen (auf Basis von Polyanilin oder Polyethylen-Dioxithiophen/Polystyrolsulfonsäure) versehen werden.

Die Möglichkeit, flexible Leiterplatten mit optoelektronisch aktiven Dünnschichtbauelementen falten oder aufrollen zu können, ist gerade bei Anzeigesystemen von besonderer Bedeutung: Es sind hier elastische, mechanisch robuste und aufrollbare bzw. faltbare Bildschirme ebenso wie aufrollbare bzw. faltbare photovoltaische Zellen denkbar. Vor allem im Bereich von tragbaren elektronischen Geräten, so genannten Hand-helds, sind überdies aufrollbare bzw. faltbare Tastaturen sowie andere Bedienelemente, bei denen Dünnschichtanordnungen mit flexibler Leiterplatte verwendet werden, äußerst vorteilhaft.

Was die Herstellung der Dünnschichtanordnungen mit flexiblen Leiterplatten als Substrat betrifft, so kann hier das so genannte Rolle-zu-Rolle-Verfahren mit besonderem Vorteil angewendet werden. Dabei wird ein flexibles Leiterplatten-Bahnmaterial verwendet, das von einer Rolle abgewickelt wird, und es wird eine vorgefertigte flexible Verkapselungs-Bahn zugeführt und über dem Dünnschichtbauelement angebracht, wobei die Verkapselungs-Bahn ebenfalls von einer Rolle abgewickelt werden kann. Denkbar ist aber hier selbstverständlich auch, entweder nur die flexible Leiterplatte oder aber nur die flexible Verkapselung als Rollenmaterial vorzusehen.

Während des Glättens bzw. Polierens kann auch eine vorübergehende Verstärkung der flexiblen Leiterplatte vorgesehen werden, wie etwa durch Führen der flexiblen Leiterplatten-Bahn über einen Tisch oder durch vorübergehendes Anordnen einer Trägerfolie auf der Rückseite der zu glättenden flexiblen Leiterplatte, um so eine Versteifung des Substrats während der Glättungs- bzw. Poliervorgänge zu gewährleisten. Diese vorübergehende Verstärkung oder Versteifung kann im Verlauf der weiteren Fertigung an einer beliebigen geeigneten Stelle wieder entfernt werden.

Die Erfindung wird nachfolgend anhand von besonders bevorzugten Ausführungsbeispielen, auf die sie jedoch nicht beschränkt sein soll, und unter Bezugnahme auf die Zeichnung noch weiter erläutert. Dabei zeigen in der Zeichnung im Einzelnen:
Fig. 1A und 1B in einer schematischen Querschnittsdarstellung bzw. Draufsicht eine Dünnschichtanordnung in Form einer Elektrolumineszenz-Vorrichtung;
die Fig. 2A, 2B und 2C in schematischen Draufsichten ähnlich jener von Fig. 1B aufeinanderfolgende Fertigungsschritte dieser Elektrolumineszenz-Vorrichtung;
Fig. 2D eine schematische Querschnittsdarstellung ähnlich jener von Fig. 1A, jedoch in der Zwischenstufe nach den Fertigungsschritten gemäß Fig. 2A bis 2C, vor Fertigstellung der Vorrichtung;

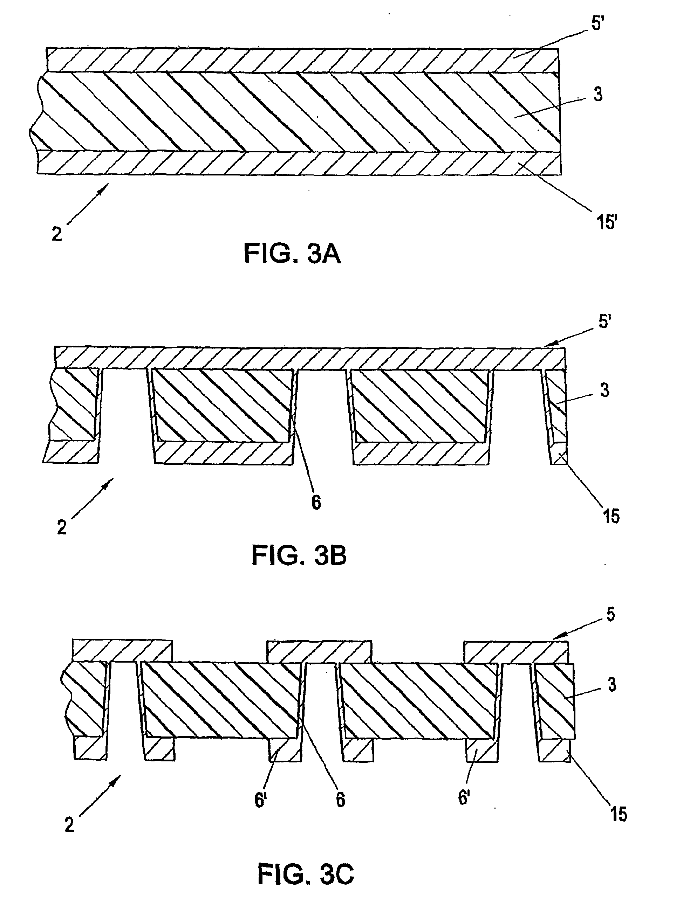

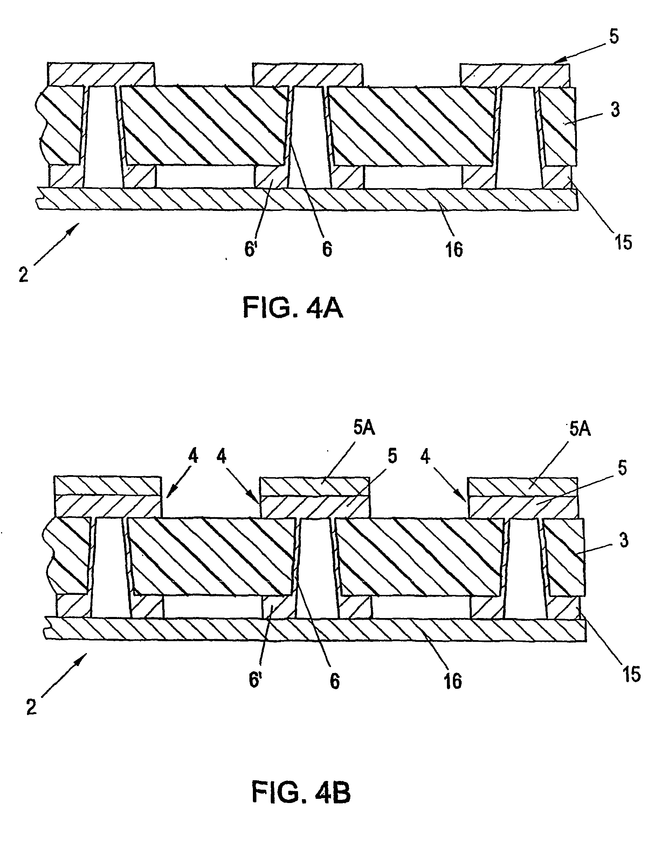

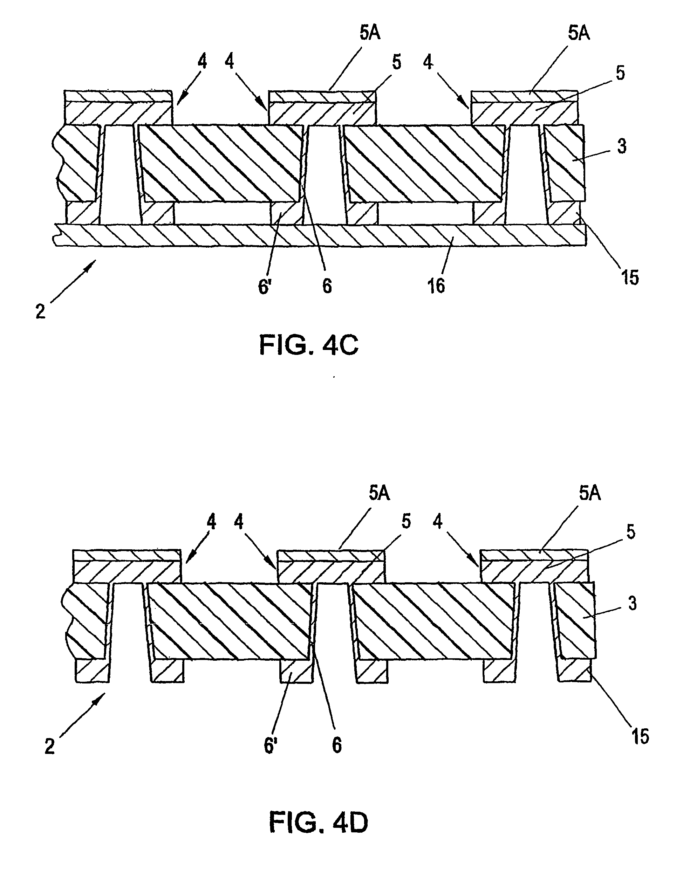

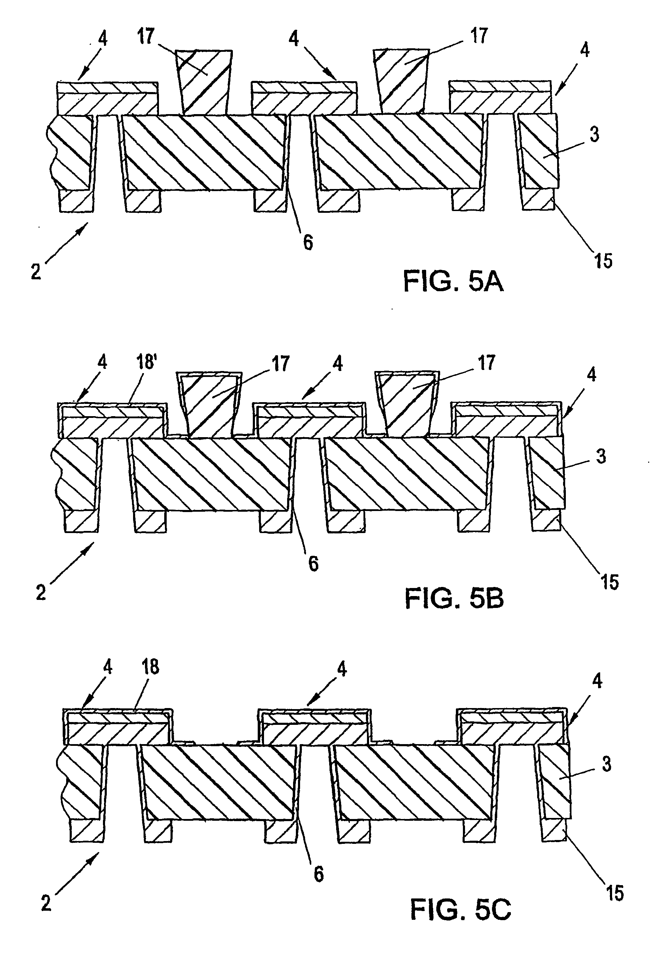

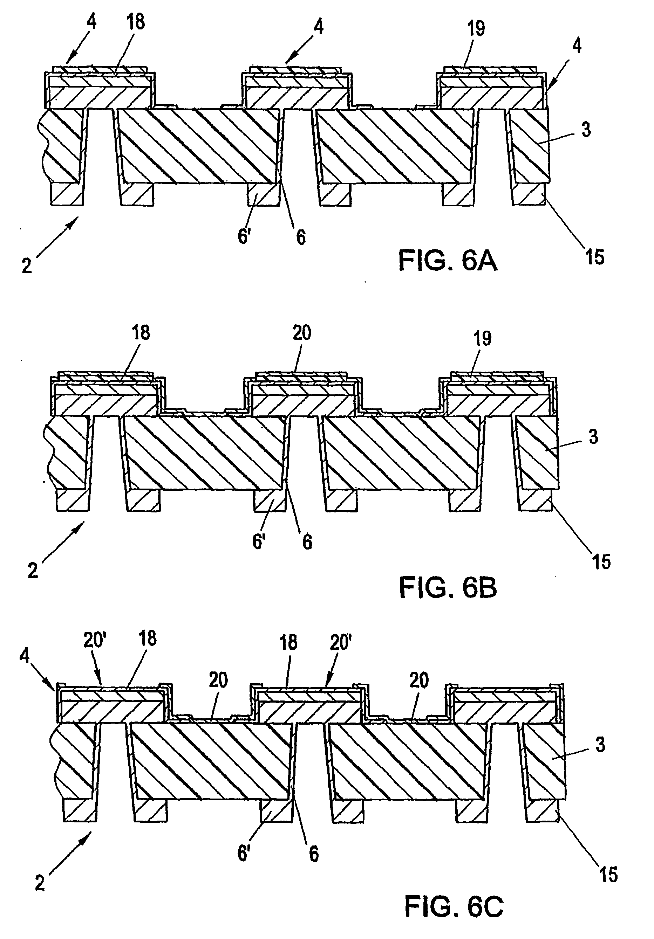

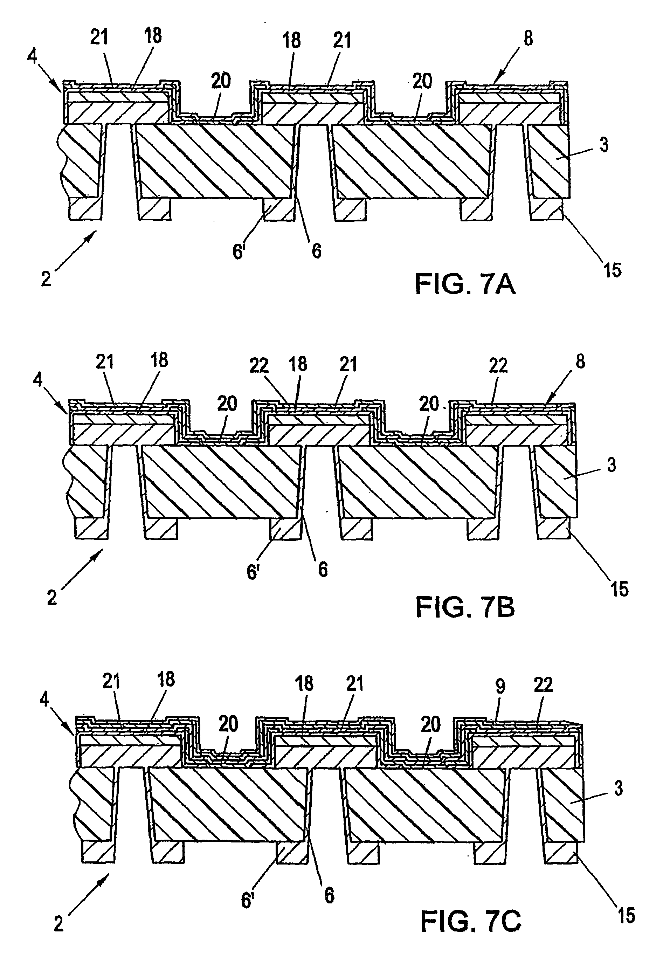

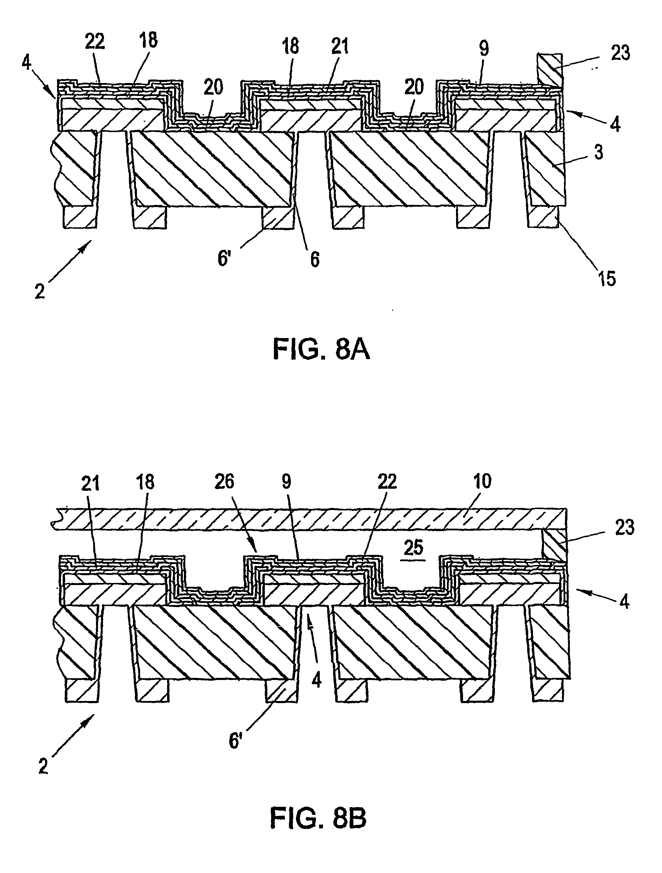

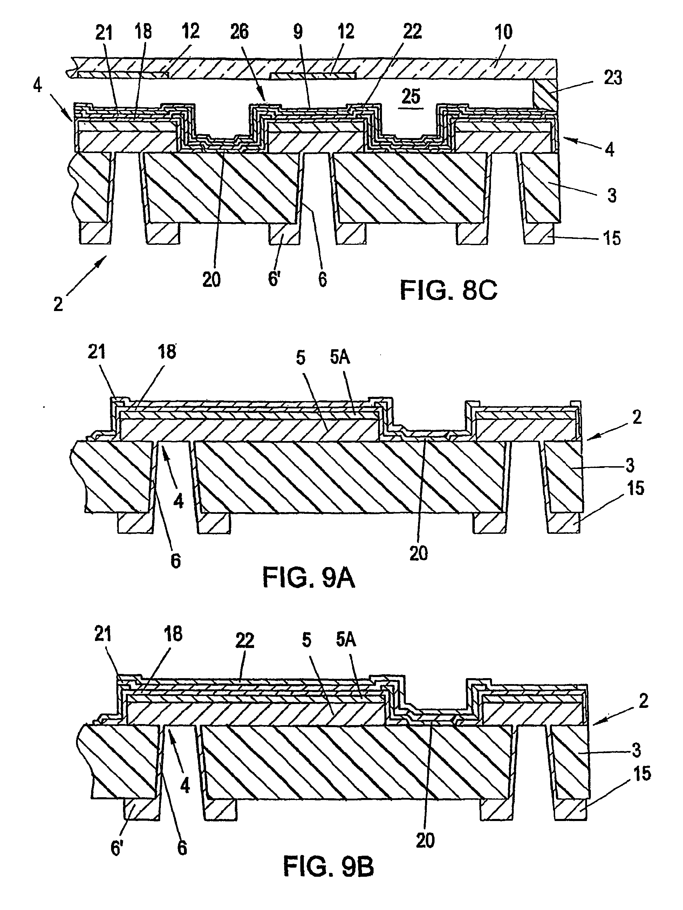

die Fig. 3 bis 8 mehr im Detail die Herstellung einer solchen Elektrolumineszenz-Vorrichtung ausgehend von einer herkömmlichen Leiterplatte, wobei im Einzelnen in Fig. 3A ein schematischer Querschnitt durch eine solche Leiterplatte gezeigt ist, in Fig. 3B und 3C die Vorbereitung dieser Leiterplatte unter Durchkontaktierung und fotolithografischer Strukturierung ihrer Metallkaschierung, und wobei in Fig. 4A in einer vergleichbaren Querschnittsdarstellung der Zustand nach Anbringung einer Passivierungsschicht an der Substratunterseite als Vorbereitung für die Anbringung einer Grundelektroden-Verstärkung gezeigt ist; in den Fig. 4B und 4C sind Detailschritte zur Anbringung einer Verstärkung der strukturierten Metallkaschierung (Fig. 4B), der Glättung der Elektrodenoberfläche (Fig. 4C), und der Zustand nach Entfernen der Passivierungsschicht (Fig. 4D) gezeigt; in den Fig. 5A bis 5C sind die Anbringung einer Fotolackstruktur zwecks Herstellung lokaler Kontaktschichten (Fig. 5A), der Aufbau mit einer abgeschiedenen Kontaktschicht (Fig. 5B) sowie schließlich der Zustand des Substrates samt Grundelektroden und Kontaktschichten nach Entfernen der temporären Fotolackstruktur (Abrisskante) (Fig. 5C) veranschaulicht; die Fig. 6A, 6B und 6C zeigen aufeinanderfolgende Schritte bei der lokalen, fotolithografisch unterstützten Anbringung einer strukturierten Passivierungsschicht an der Substratoberseite; die Fig. 7A, 7B und 7C zeigen einzelne Schritte bei der Anbringung von optoelektronisch aktiven organischen Schichten (Fig. 7A), einer oberen lichtdurchlässigen Kontaktschicht (Fig. 7B) und einer oberen lichtdurchlässigen Deckelektrode (Fig. 7C) zwecks Vervollständigung des Dünnschichtbauelement-Aufbaus; die Fig. 8A, 8B und 8C zeigen schließlich die abschließenden Schritte zur Anbringung einer Verkapselung für die Elektrolumineszenz-Dünnschichtanordnung mit Hilfe eines Klebewulstes (Fig. 8A), auf dem die Verkapselungsschicht angebracht wird (Fig. 8B), und zur Integration lateral strukturierter Farbwandlerschichten (Fig. 8C);
die Fig. 9A bis 9D veranschaulichen aufeinanderfolgende Herstellungsschritte zur Fertigung einer fotovoltaischen Zelle mit organischem, optoelektronischem Dünnschichtmaterial;
die Fig. 10 und 11 zeigen je eine ähnliche schematische Querschnittsdarstellung einer Dünnschichtanordnung mit einer "organischen" Diode (Fig. 10) bzw. mit einem (Feldeffekt-) Transistor (Fig. 11);
Fig. 12 zeigt in einer schematischen Querschnittsdarstellung eine flexible Dünnschichtanordnung, mit einer flexiblen Leiterplatte als Substrat und mit einer flexiblen Verkapselung über dem Dünnschichtbauelement, wobei die Dickenmaße der einzelnen Lagen in ihrer Relation zueinander ungefähr maßstäblich veranschaulicht sind;
die Fig. 13A und 13B zeigen eine solche flexible Dünnschichtanordnung in weiter vereinfachter schematischer Querschnittsdarstellung, einmal in unbelastetem Zustand (Fig. 13A) und sodann in einem gebogenen Zustand (Fig. 13B), wobei ersichtlich ist,
   dass bei Vorsehen des Dünnschichtbauelements in der neutralen Ebene der Anordnung auf dieses Dünnschichtbauelement keine Zug- bzw. Druckkräfte wirken, wie sie in den äußeren Bereichen der Anordnung wirken;

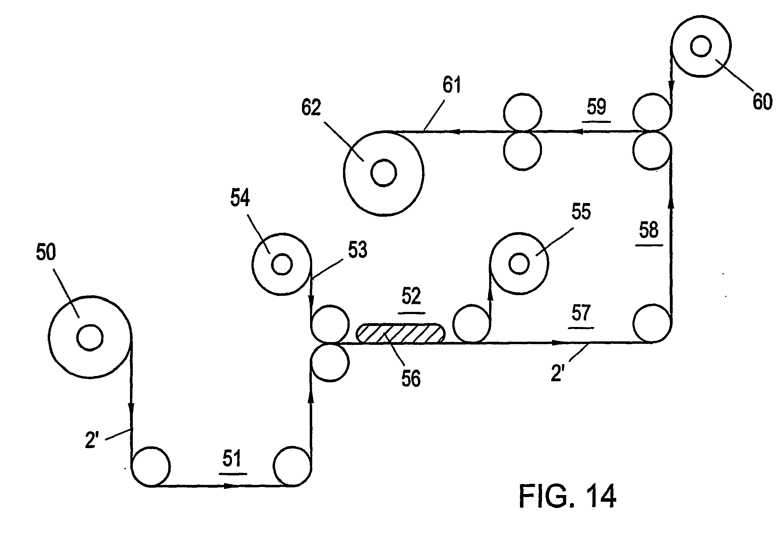

Fig. 14 zeigt ein Schema zur Veranschaulichung der Herstellung einer flexiblen Dünnschichtanordnung in einem Rolle-zu-Rolle-Prozess; und
Fig. 15 zeigt ein Detailschema zur Veranschaulichung der Anbringung einer vorübergehenden Versteifung im Zuge eines mechanischen Glättungs- und Poliervorganges während der Herstellung der flexiblen Dünnschichtanordnung.

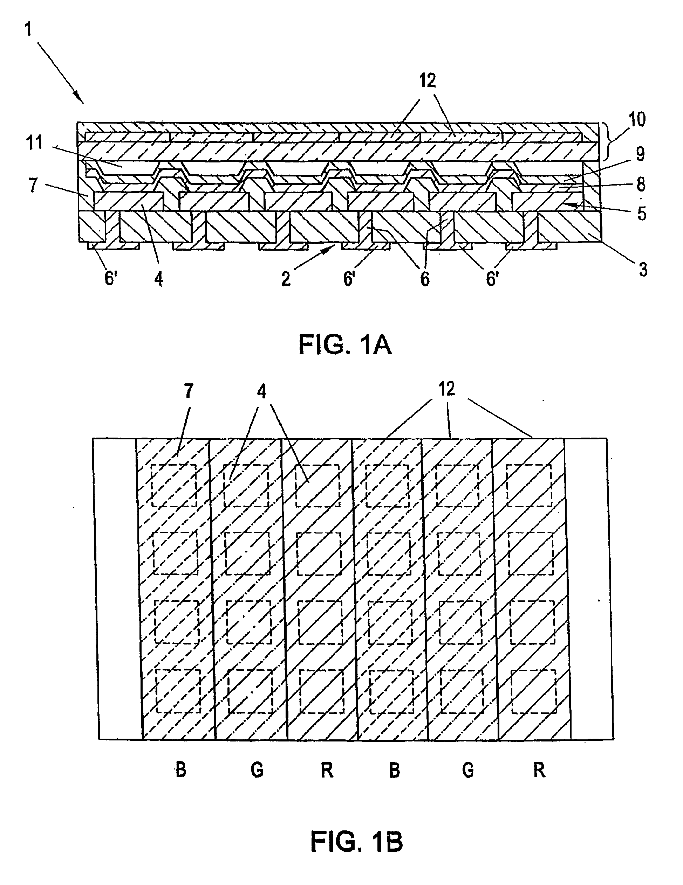

In Fig. 1A ist eine Dünnschichtanordnung in Form einer Elektrolumineszenz-Vorrichtung 1 schematisch in einer Querschnittsdarstellung gezeigt. Diese Elektrolumineszenz-Vorrichtung 1 weist als Substrat eine herkömmliche Leiterplatte 2 mit einem isolierenden Grundkörper 3 auf, auf dem lokale Grundelektroden 4 als verbleibende Teile der strukturierten Metallkaschierung oder Leiterschicht 5 der Leiterplatte 2 vorliegen. Diese Grundelektroden 4 sind über mechanisch oder Laser-gebohrte Durchkontaktierungen 6 mit Kontaktstellen 6' an der Substrat-Unterseite verbunden, so dass von der Substratunterseite entsprechende Steuersignale an die Grundelektroden 4 angelegt werden können. Diese Grundelektroden 4 sind beispielhaft aus Fig. 1B als quadratische Flächen erkennbar, und sie sind durch eine in Draufsicht gitterförmige Isolierstruktur 7 voneinander getrennt.

Oberhalb der Grundelektroden 4 und der Isolierstruktur 7 ist insbesondere flächig eine organische Elektrolumineszenz-Dünnschichtstruktur angebracht, die im Prinzip beispielsweise wie in EP 1 087 649 A oder EP 0 854 662 A ausgebildet sein kann.

Über dem organischen Elektrolumineszenzschichtsystem 8 befindet sich eine transluzente leitfähige, bevorzugt ebenfalls flächig, gegebenenfalls in Streifenform oder aber auch in Elementform angebrachte Deckelektrode 9. Der gesamte bisher beschriebene Aufbau ist mit Hilfe einer transluzenten Verkapselungsschicht 10, unter Belassung eines Gasvolumens 11 unterhalb hiervon, zur Umgebung hin abgeschlossen, wobei in diese Verkapselungsschicht 10 weiters in an sich bekannter Weise (s. EP 0 854 662 A) Farbwandler- bzw. Indexanpassungsschichten 12 integriert sind.

In der schematischen Draufsicht von Fig. 1B ist ersichtlich, dass diese Farbwandler- bzw. Indexanpassungsschichten 12 streifenförmig, beispielsweise mit den Grundfarben Blau, Grün und Rot, vorliegen (was schematisch durch unterschiedliche Schraffierungen B, G, R in dieser Fig. 1B angedeutet wurde). In Zeilenrichtung (gemäß der Darstellung in Fig. 1B) liegen somit immer drei Farbpunkte Blau, Grün und Rot nebeneinander, und die Ansteuerung dieser Farbpunkte in Zeilenrichtung ebenso wie in Spaltenrichtung erfolgt über die Durchkontaktierungen 6 durch Anlegen von entsprechenden Steuersignalen an die jeweiligen Grundelektroden 4. Die Deckelektrode 9 hingegen kann, wenn sie flächig aufgebracht ist, an einem einheitlichen Potential liegen.

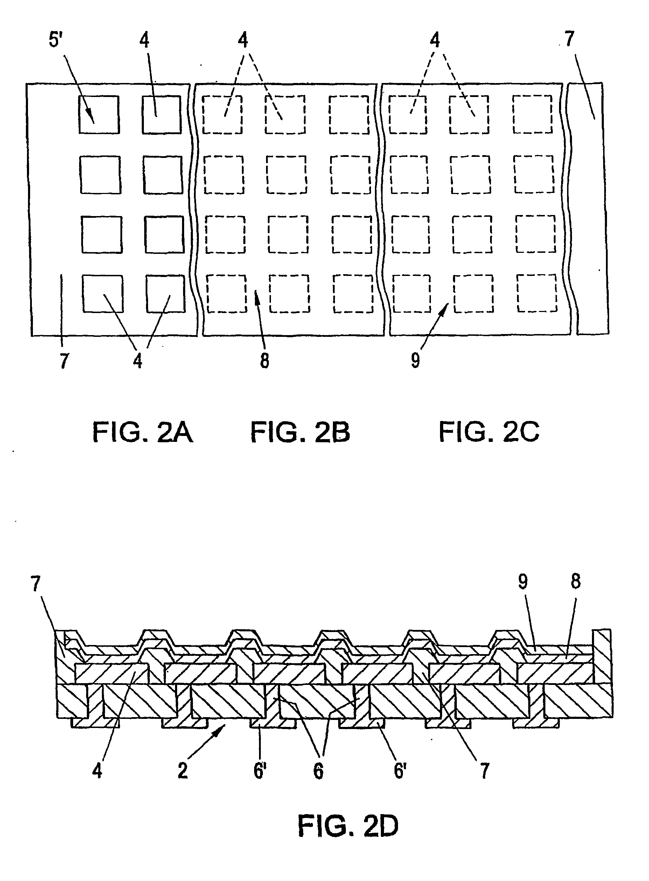

In den Fig. 2A, 2B und 2C sind in schematischen Draufsichten verschiedene Fertigungsstufen bei der Herstellung der eigentlichen Elektrolumineszenz-Vorrichtung (noch ohne Verkapselung) veranschaulicht, wobei das nach diesen Fertigungsschritten erhaltene Zwischenprodukt in Fig. 2D in schematischer Querschnittdarstellung ersichtlich ist.

Gemäß Fig. 2A liegt bereits eine lateral strukturierte Leiterschicht 5' vor, um so eine Matrix von Grundelektroden 4 zu bilden. Zwischen diesen in Matrix-Form vorliegenden Grundelektroden 4 befindet sich die gitterartige Isolierstruktur 7, die die einzelnen Grundelektroden 4 voneinander trennt. Im nachfolgenden Schritt, vgl. Fig. 2B, wird das organische Elektrolumineszenzschichtsystem 8 flächig aufgebracht, s. außer Fig. 2B auch Fig. 2D. Danach wird die lichtdurchlässige Deckelektrode 9 - ebenfalls flächig - abgelagert, wodurch die Anordnung gemäß Fig. 2D erhalten ist. Hierzu ist ergänzend auszuführen, dass vorab die Leiterplatte 2 bereits zur Anfertigung der Laser-Vias 6 samt Kontaktstellen 6' behandelt wurde, bevor die Strukturierung der Leiterschicht 5 zur Bildung der Grundelektroden 4 (s. Fig. 2A) erfolgte.

In Fig. 3A ist in einer schematischen Querschnittsdarstellung (in ähnlicher Weise sind alle weiteren Figuren schematische Querschnittsdarstellungen) eine Leiterplatte 2 veranschaulicht, die eine doppelseitige Metallkaschierung 5 (oberseitig) bzw. 15 (unterseitig) auf einem dielektrischen Grundkörper 3, z.B. aus Epoxidharz, aufweist. Die Metallkaschierungen 5, 15 bestehen beispielsweise wie üblich aus Kupfer.

Diese das Substrat der vorliegenden Dünnschichtanordnung bildende Leiterplatte 2 wird sodann in einem ersten Schritt mit Durchkontaktierungen 6 versehen, vgl. Fig. 3B, wobei diese Durchkontaktierungen im Hinblick auf die gewünschten eng beisammen liegenden Bildpunkte, d.h. das hohe Auflösungsvermögen der herzustellenden Elektrolumineszenz-Vorrichtung 1, als Laserbohrungen mit galvanischer Kupferbeschichtung der Bohrungswände hergestellt werden. Dabei wird bevorzugt eine derartige Durchkontaktierung oder Laserbohrung 6 unter der jeweils vorzusehenden Grundelektrode 4 hergestellt, um die endgültig erhaltene enge Matrix-Anordnung der Grundelektroden 4 mit einer entsprechenden Ansteuerungsmöglichkeit von der Unterseite des Substrates her ausbilden zu können.

Im nächsten Schritt erfolgt gemäß Fig. 3C eine fotolithografische Strukturierung der Metallkaschierungen, d.h. der Leiterschichten 5, 15 an der Oberseite und Unterseite des Grundkörpers 3 der Leiterplatte 2. Eine derartige Strukturierung ist ebenfalls an sich herkömmlich, so dass die danach erhaltene Struktur in Fig. 3C ohne die üblichen Zwischenschritte dargestellt werden kann. Die jeweils erhaltenen Strukturen der oberen Leiterschicht und unteren Leiterschicht sind zwecks Unterscheidung der vollflächigen Leiterschichten nunmehr anstatt mit 5' bzw. 15' mit 5 bzw. 15 bezeichnet. An der Unterseite bilden dabei die verbleibenden Teile 15 der Leiterschicht die Kontaktstellen 6'.

Als Nächstes wird an der Substratunterseite eine temporäre Passivierungsschicht 16 angebracht, wie aus Fig. 4A ersichtlich ist. Diese temporäre Passivierungsschicht 16 dient dazu, diese unterseitigen Bereiche der Leiterplatte 2 im Hinblick auf die nachfolgende Anbringung einer chemischen bzw. elektrochemischen Verstärkung der Leiterschicht 5 an den Stellen der herzustellenden Grundelektroden 4 vorübergehend zu passivieren. Diese Passivierungsschicht 16 kann fotolithografisch, wie an sich bekannt, aufgebracht werden.

Wie bereits angedeutet erfolgt als nächster Schritt eine chemische bzw. elektrochemische Verstärkung der strukturierten Leiterschicht 5, wobei die Verstärkungslagen in Fig. 4B mit 5A angegeben sind. Diese metallische Schicht 5A bildet zusammen mit der strukturierten Leiterschicht 5 die jeweiligen Grundelektroden 4, beispielsweise in der Matrix-Anordnung gemäß Fig. 2A. Diese Grundelektroden 4 sind jedoch in dieser Form noch nicht für den Aufbau der gewünschten aktiven oder passiven elektronischen Dünnschichtbauelemente, hier der optoelektronischen EL-Vorrichtung 1, geeignet, da die Oberfläche der Leiterschicht 5 an sich ebenso wie jene der mit der Verstärkung 5A versehenen Leiterschicht 5 viel zu rau ist. Es wird daher in einem nächsten Schritt eine Glättung oder ein Polieren der Grundelektroden 4 durchgeführt, um eine niedrige Oberflächenrauigkeit, mit einer mittleren Oberflächenrauigkeit von maximal 10 nm oder, bevorzugt sogar maximal 3 nm, über Flächenbereiche von 20 x 20 µm², zu erreichen. Dieser geglättete Zustand ist in Fig. 4C dargestellt. Das Glätten oder Polieren kann auf an sich herkömmliche Weise erfolgen, wie etwa mechanisch, chemisch, elektrochemisch, chemisch-mechanisch sowie durch Ionenätzen. Es können dabei selbstverständlich auch Kombinationen dieser Verfahrenstechniken eingesetzt werden.

Die herbeizuführende Oberflächenrauigkeit hängt selbstverständlich von der Art der jeweiligen Applikation, d.h. vom jeweils anzubringenden Dünnschichtbauelement ab.

Zu erwähnen ist auch, dass es nicht unbedingt erforderlich ist, eine metallische Verstärkung 5A für die Grundelektroden 4 vorzusehen, da auch die Metallkaschierung, d.h. Leiterschicht 5 der Leiterplatte 2, bereits eine ausreichende Dicke aufweisen kann. Weiters ist es im Prinzip auch denkbar, die Reihenfolge der Strukturierung der Leiterschicht 5 (s. Fig. 3C) und der Glättung der Oberfläche der Leiterschicht (s. Fig. 4C) zu vertauschen, d.h. die Glättung der Leiterschicht 5' insgesamt zuerst vorzunehmen und erst danach die Leiterschicht 5' zur Bildung der Grundelektroden 4, d.h. zur Bildung der strukturierten Leiterschicht 5, entsprechend fotolithografisch zu ätzen.

In einem diese Phase der Herstellung abschließenden Schritt wird die untere Passivierungsschicht 16 entfernt, so dass nunmehr die Substratstruktur gemäß Fig. 4D erhalten ist.

In der nächsten Phase wird auf der nun geglätteten Grundelektrode 4 eine Kontaktschicht angebracht, wobei als erstes gemäß Fig. 5A eine temporäre Fotolackstruktur in der Art von Abrisskanten 17 in den Zwischenräumen zwischen den Grundelektroden 4 angebracht wird. Darauf wird die gesamte Oberseite der erhaltenen Struktur mit einer Lage 18' aus Kontaktschichtmaterial überzogen, wobei in den unteren Bereichen der Abrisskanten 17 kein Kontaktschichtmaterial erfolgt, so dass in einem nachfolgenden Entfernungsschritt (Ätzschritt) die Abrisskanten 17 entfernt werden können, wobei in den übrigen Bereichen der Oberfläche die gewünschte Kontaktschicht 18 zurückbleibt, vgl. Fig. 5B und 5C.

Die Kontaktschicht 18 dient zur elektrischen Kontaktierung der nunmehr aufzubringenden nächsten Schicht des jeweiligen Dünnschichtaufbaus ebenso wie zur Stabilisierung der Haftung dieses Dünnschichtaufbaus auf der Grundelektrode 4 sowie schließlich auch zur Passivierung der Leiterschicht 5 bzw. ihrer Verstärkung 5a, indem durch das Einbringen der Kontaktschicht 18 eine etwaige Kontamination des Dünnschichtsystems durch Interdiffusion von Fremdsubstanzen aus der Leiterschicht 5 bzw. ihrer Verstärkung 5a unterbunden wird. Das Material für die jeweilige Kontaktschicht 18 ist naturgemäß wiederum abhängig vom jeweiligen anzubringenden Dünnschichtbauelement geeignet zu wählen, und sie besteht beispielsweise aus einem Metall wie Aluminium, Gold, Palladium oder Platin, einer Metalllegierung, Kohlenstoff oder einer helbleitenden Verbindung, kann aber auch aus einer leitfähigen Suspension oder einer Lösung (z.B. Polyanilin, Polyethylen-Dioxithiophen/Polystyrolsulfonsäure) bestehen.

Die Kontaktmaterial-Lage 18' kann mittels üblicher Dünnschichtverfahren, wie etwa durch thermisches Verdampfen, Kaltkathodenzerstäubung, Elektronenstrahlverdampfung, Beschichtung mittels Laserpulsen sowie durch Beschichtungsverfahren aus der flüssigen Phase, wie z.B. Tauch-, Sprüh-, Schleuder- und Tintenstrahldruck-Verfahren, aufgebracht werden, wobei auf eine physikalische bzw. chemische Adsorption des Kontaktmaterials auf der Leiterschicht 5 bzw. ihrer Verstärkung 5a zu achten ist; diese physikalische bzw. chemische Adsorption ist für ein Haften bzw. Nicht-Ablösen des Kontaktmaterials auf bzw. von der Leiterschicht 5, 5a von Bedeutung. Im Fall von gleichförmigen Beschichtungsverfahren aus der flüssigen Phase kann die laterale Strukturierung der Kontaktschicht 18 nach der Beschichtung der Leiterplatte 2 beispielsweise mit Trockenätzverfahren erfolgen. Kommen derartige Prozesse zur Anwendung, entfällt die Strukturierung mittels des Abrisskantenverfahrens.

Als Nächstes erfolgt nun die Anbringung einer oberen Passivierungsschicht, um die Bereiche zwischen den Grundelektroden 4 samt darüber angebrachten Kontaktschichten 18 zu passivieren und so daran zu hindern, dass über diese Bereiche aus dem Grundkörper 3 der Leiterplatte 2 Substanzen in den noch anzubringenden Dünnschichtaufbau des jeweiligen Dünnschichtbauelements eindringen. Hierfür wird in einem ersten Schritt gemäß Fig. 6A eine neuerliche temporäre Fotolackstruktur 19 auf den Kontaktschichten 18 über den Grundelektroden 4 angebracht, und danach wird darüber das Material für die Passivierungsschicht 20 abgeschieden, siehe Fig. 6B. Im Anschluss daran wird über den Grundelektroden 4 die Fotolackschicht samt Passivierungsschicht fotolithografisch entfernt, so dass eine strukturierte Passivierungsschicht 20 nur in den Zwischenzonen, wo das Basismaterial des Isoliergrundkörpers 3 der Leiterplatte 2 freigelegt war, zurückbleibt, s. Fig. 6C. Über Fenster 20' in dieser Passivierungsschicht 20 liegen die Kontaktschichten 18 mit den darunter liegenden Grundelektroden 4 frei. Die Passivierungsschicht 20 ist selbstverständlich nur dann zweckmäßig bzw. anzubringen, wenn die angesprochene Kontamination des spezifischen Dünnschichtaufbaus durch Substanzen, die aus dem dielektrischen Material des Grundkörpers 3 diffundieren können, zu befürchten ist. Wenn eine solche Diffusion von Substanzen nicht zu befürchten ist, kann die Anbringung der Passivierungsschicht 20 auch unterbleiben, es wäre dann aber eine andere Isolierstruktur (7 in Fig. 1A und 1B) zwischen den Grundelektroden 4 anzubringen. Das Material der Passivierungsschicht 20 ist wiederum abhängig von den verwendeten Materialien, insbesondere vom Material des Grundkörpers 3, zu wählen. Wie beschrieben wird sie zweckmäßig fotolithografisch strukturiert (vgl. die Fig. 6A und 6B), und das Material der Passivierungsschicht 20 kann mittels üblicher Dünnschichttechniken, etwa durch thermisches Verdampfen, Kaltkatodenzerstäubung usw., aufgebracht werden, wobei auf eine für das Haften hinreichende physikalische bzw. chemische Adsorption des Passivierungsmaterials auf dem Grundkörper 3 zu achten ist. Als Material für die Passivierungsschicht 20 kann beispielsweise Siliziumoxid, ein Sol-Gel-System oder eine Epoxidverbindung verwendet werden.

Alternativ zur Technik gemäß den Fig. 6A bis 6C ist es auch denkbar, vorweg eine vollflächige gleichförmige Aufbringung von Passivierungsmaterial, etwa in Form eines Laminats, vorzusehen und diese Passivierungsschicht erst nachträglich fotolithografisch zu strukturieren, um schließlich die Struktur gemäß Fig. 6C zu erhalten.

Die so erhaltene Anordnung ist nunmehr bereit für die Anbringung der jeweiligen elektronischen Schichten in Dünnschichttechnik, zum Aufbau des gewünschten Dünnschichtbauelementes 8, im vorliegenden Fall einer optoelektronischen aktiven organischen Dünnschichtstruktur; zur Erzielung der Elektrolumineszenz(EL)-Vorrichtung 1 (s. Fig. 1A) werden dabei ein oder mehrere optoelektronisch aktive organische Schichten 21 auf dem vorbereiteten Substrat gemäß Fig. 6C abgeschieden, so dass die Anordnung gemäß Fig. 7A erhalten wird. Wie dabei ersichtlich wird beispielsweise über der gesamten Fläche das organische EL-Material abgelagert, wodurch die Herstellung besonders einfach wird. Ebenso wie dieses (gegebenenfalls mehrlagige) organische EL-Dünnschichtsystem 21 (dessen Dicke einige wenige nm bis einige hundert nm betragen kann) wird nachfolgend auch eine transparente oder transluzente Kontaktschicht 22, s. Fig. 7B, flächig aufgetragen; auch die nachfolgend angebrachte transparente oder transluzente Deckelektrode 9 wird flächig aufgetragen, s. Fig. 7C. Es ist jedoch abweichend hiervon auch denkbar, die obere Kontaktschicht 22 sowie die Deckelektrode 9 anstatt vollflächig auch streifenweise oder symbolweise zu strukturieren.

Als Beispiel für die organischen optoelektronisch aktiven Schichtmaterialien, zur Realisierung der Elektrolumineszenz-Vorrichtung 1, können Poly- und Oligophenyle, Arylamine, Poly- und Oligoazometine genannt werden. Für die transparenten oder transluzenten Kontaktschichten 22 sowie die Deckelektroden 9 können transparente oder semitransparente Metalle, Metalllegierungen, Halbleiterverbindungen (mit einer Schichtdicke <50 nm), leitfähige Metalloxide (z.B. Aluminium-dotiertes Zinkoxid, Zinn-dotiertes Indiumoxid usw.), leitfähige Sol-Gel-Systeme und/oder leitfähige Suspensionen und Lösungen (auf Basis von Polyanilin, Polyethylen-Dioxithiophen/Polystyrolsulfonsäure) verwendet werden.

Abschließend wird die so erhaltene Dünnschichtanordnung (s. Fig. 7C) noch mit einer Schutzabdeckung versehen, wozu als erstes, gemäß Fig. 8A, ein für Gas und Feuchte undurchlässiger Klebewulst 23 randseitig angebracht wird. Über diesem Klebewulst 23 wird anschließend die lichtdurchlässige Verkapselungsschicht 10 angebracht, um die eigentlichen Dünnschichtbauelemente 26 mit den Grundelektroden 4, der Kontaktschicht 18, der Dünnschichtstruktur 8, der oberen Kontaktschicht 22 und der Deckelektrode 9 zu verkapseln, wobei ein Gasvolumen 25 verbleibt, in dem in an sich herkömmlicher Weise Gettermaterialien für Sauerstoff und/oder Wasser bzw. Feuchtigkeit enthalten sein können.

Wie sodann in Fig. 8C dargestellt ist, können gewünschtenfalls auch lateral strukturierte Farbwandlerschichten 12 (s. außer Fig. 8C auch Fig. 1A und 1B) in die Verkapselungsschicht 10 über dem Gasvolumen 25 und den einzelnen Dünnschichtbauelementen 26 integriert werden.

Auf diese Weise ist nunmehr die gewünschte Dünnschichtanordnung fertiggestellt, die an den Kontaktstellen 6' mit den erforderlichen Steueranschlüssen versehen werden kann. Zusätzlich können auf der Leiterplatte 2 auch in an sich herkömmlicher und hier nicht näher dargestellter Weise Bauelemente montiert werden, um gewünschte Schaltungsfunktionen zu realisieren.

In den Fig. 9A bis 9D ist in verschiedenen Herstellungsschritten ein anderes Ausführungsbeispiel veranschaulicht, nämlich eine Dünnschichtanordnung mit einer fotovoltaischen Zelle aus einem organischen optoelektronisch aktiven Schichtsystem, wobei die Herstellung im Prinzip sehr ähnlich wie vorstehend anhand der Fig. 3A bis 8C beschrieben erfolgen kann.

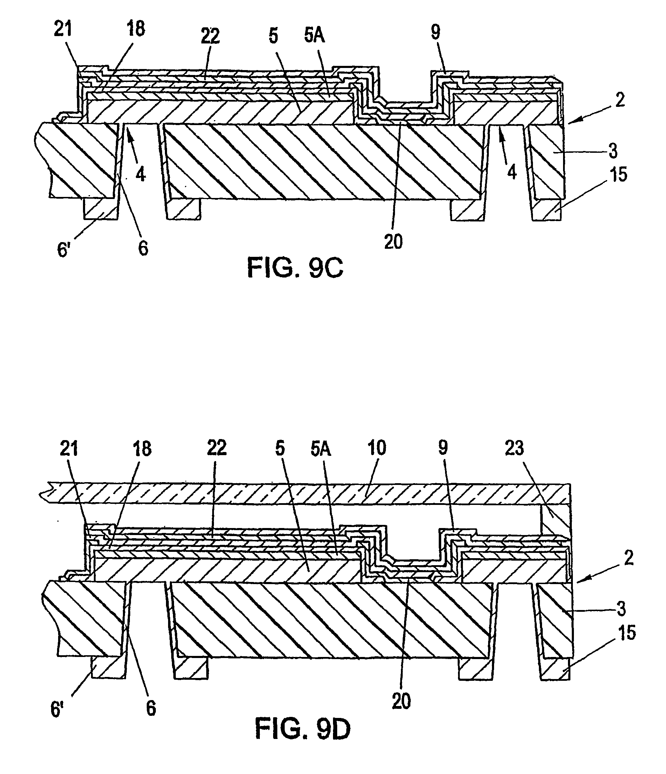

Im Einzelnen wird ähnlich wie in Fig. 7A gezeigt, auf entsprechende Grundelektroden 4, bestehend aus der strukturierten Leiterschicht 5, einer Verstärkung 5A und einer Kontaktschicht 18, das gewünschte optoelektronisch aktive organische Schichtsystem 21 abgeschieden, wonach eine lichtdurchlässige Kontaktschicht 22 (s. Fig. 9B) und darüber eine lichtdurchlässige Deckelektrode 9 (s. Fig. 9C) wiederum flächig abgeschieden werden können. Schließlich kann wiederum in einer Weise wie vorstehend anhand der Fig. 8A und 8B erläutert eine lichtdurchlässige Verkapselungsschicht 10 mit einem randseitigen Gas- und Feuchte-undurchlässigen Klebewulst 23 angebracht werden, wie in Fig. 9D veranschaulicht ist.

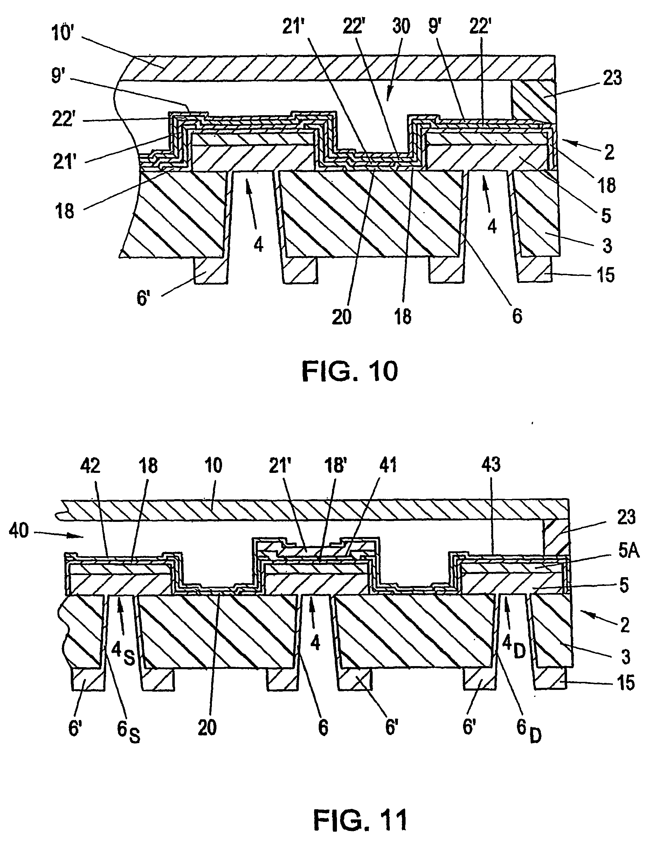

In Fig. 10 ist ein weiteres Ausführungsbeispiel in Form einer auf einer Leiterplatte 2 integrierten organischen Diode 30 veranschaulicht, wobei hier wiederum in vergleichbarer Weise, wie vorstehend erläutert, über einer Grundelektrode 4 mit einer Kontaktschicht 18 ein entsprechendes organisches Dioden-Dünnschichtsystem 21' aufgebracht ist. Darüber befindet sich eine obere Kontaktschicht 22', die hier nicht lichtdurchlässig sein muss, und eine Deckelektrode 9', die ebenfalls nicht lichtdurchlässig zu sein braucht. Zu ersehen sind weiters aus Fig. 10 wiederum die strukturierte untere Metallkaschierung 15 und der Grundkörper 3 der Leiterplatte 2 sowie weiters ein dichter Klebewulst 23 und eine Verkapselungsschicht 10', wobei auch hier eine opake Ausbildung vorliegen kann.

Ähnliches gilt auch für die Transistorstruktur 40 gemäß Fig. 11, wobei wiederum über der Grundelektrode 4, bestehend aus der strukturierten oberen Leiterschicht 5 und einer Verstärkung 5A, eine Kontaktschicht 18' angebracht ist, die beispielsweise den Gate-Kontakt der gebildeten Feldeffektstruktur 40 bildet. Über dieser Kontaktschicht 18' der Transistorstruktur 40 ist eine Isolierschicht 41, beispielsweise aus Aluminiumoxid, angebracht, über der wiederum eine organisch aktive Schicht 21' aufgebracht ist, die einerseits mit einer Source-Kontaktschicht 42 und andererseits mit einer Drain-Kontaktschicht 43 in Verbindung steht. Diese Kontakte werden über seitlich der Transistorstruktur 40 vorhandene Grundelektroden 4_{S}, 4_{D} bzw. über deren korrespondierende Durchkontaktierungen 6_{S}, 6_{D} und Kontaktstellen 6' von der Unterseite her kontaktiert.

In ähnlicher Weise können auch andere Dünnschichtbauelemente, und zwar aktive Bauelemente ebenso wie passive Bauelemente, direkt auf dem Leiterplattensubstrat 2 aufgebaut bzw. in dieses integriert werden, wobei wesentlich jeweils die Glättung der strukturierten, gegebenenfalls verstärkten Leiterschicht 5 (bzw. 5A), somit der Grundelektroden 4 oder unterseitigen Elektroden durchzuführen ist. Auf dieser geglätteten oder polierten Grundelektrode wird dann die beschriebene Kontaktschicht zur Herstellung des Kontakts und der stabilen Adhäsion der Dünnschichtaufbauten vorgesehen. Andere an sich herkömmliche Bauelemente, die mit der erfindungsgemäßen Technik auf Leiterplatten integriert werden können, sind beispielsweise Sensoren, wobei im Fall von optischen Sensoren entsprechende lichtdurchlässige obere Kontaktschichten, Elektroden und Verkapselungsschichten vorzusehen sind.

Die vorstehend erläuterten Techniken können im Wesentlichen in gleicher Weise bei starren Leiterplatten wie bei flexiblen Leiterplatten angewandt werden. Derartige flexible Leiterplatten 2 haben beispielsweise einen isolierenden Grundkörper 3 aus einer biegsamen Folie aus einem Polyimid, aus Polyethylennaphthalat, aus Polyester oder aus Polyetheretherketon, und es kann in vergleichbarer Weise als Leiterschicht 5 eine Metallkaschierung, insbesondere aus Kupfer, einseitig oder aber beidseitig, vorliegen.

Um schließlich insgesamt eine flexible Gesamtanordnung zu erhalten, sind zwar bei der Anbringung der Dünnschichtstruktur 8 sowie der Kontaktschichten 18 und der Deckelektroden 9 praktisch keine Abänderungen im Vergleich zu den vorstehend beschriebenen Techniken erforderlich, und insbesondere eignen sich die - extrem dünnen - Dünnschichtsysteme 8 in vorteilhafter Weise für derartige flexible Strukturen, es ist jedoch dann insofern eine Anpassung notwendig, als für die Verkapselung 10 darauf zu achten ist, dass keine starren Gläser aufgeklebt werden, sondern dass biegsame dünne Glaslaminate oder aber Polymer-Oxid-Verbundschichtsysteme oder dergl. flexible Verkapselungslagen 10 eingesetzt werden.

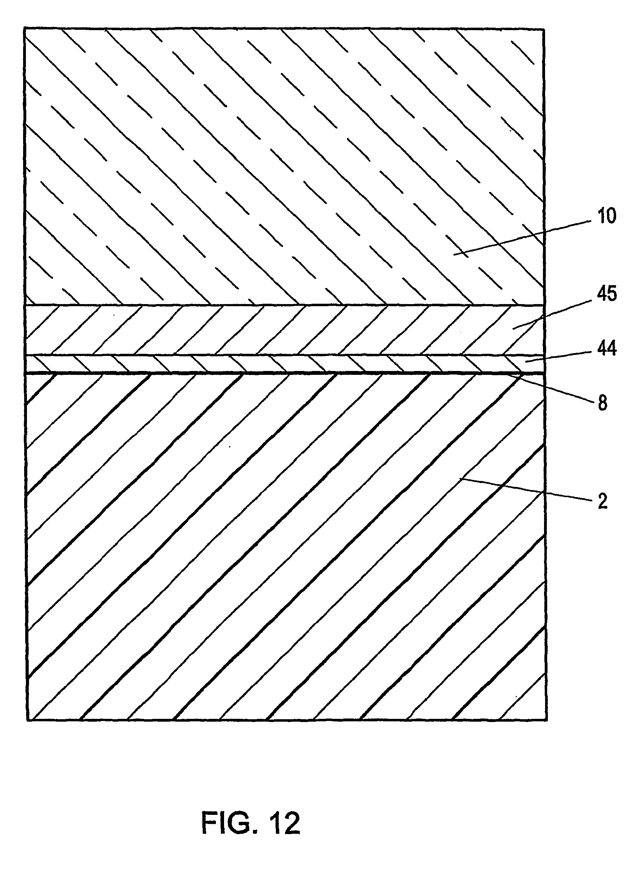

Eine derartige Verkapselungslage 10 aus einem flexiblen Material kann über eine Adhäsions-Zwischenschicht 44 sowie eine als Sperrschicht gegen Feuchte und Luft wirkende Passivierungsschicht 45 auf der flexiblen Leiterplatte 2 bzw. über dem darauf angebrachten Dünnschichtsystem 8 angebracht werden, wie dies schematisch in Fig. 12 dargestellt ist. Bei der Darstellung in Fig. 12 wurde im Übrigen darauf geachtet, die relativen Dickenverhältnisse möglichst maßstäblich zu veranschaulichen, wobei sich auch ergibt, dass das Dünnschichtbauelement 8 in der neutralen Ebene der gesamenten flexiblen Dünnschichtanordnung zu liegen kommt. Dies wird je nach Material und Form vor allem der Verkapselungsschicht 10 sowie der flexiblen Leiterplatte 2 ungefähr in der Mittenebene der gesamten Anordnung sein.

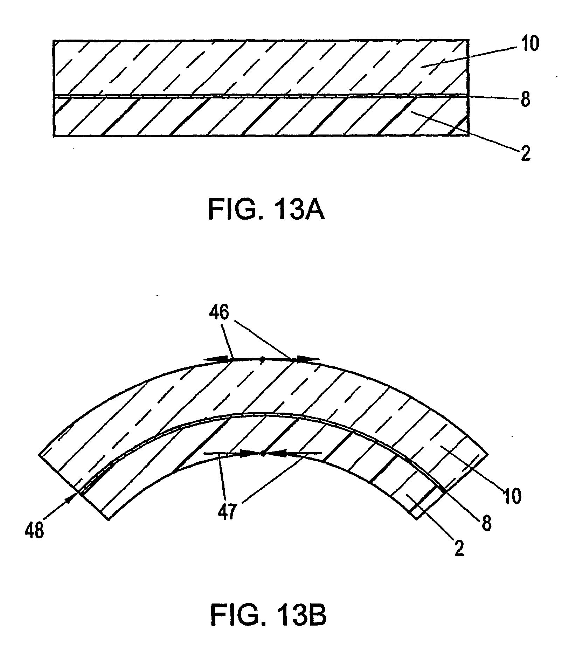

Eine solche Dünnschichtanordnung von flexibler Natur ist in Fig. 13A nochmals, noch mehr vereinfacht, dargestellt, und in Fig. 13B ist diese Dünnschichtanordnung in einem gebogenen oder teilweise gefalteten Zustand gezeigt. Dabei wirken im Biegebereich außen auf das Material Zugkräfte ein, wie dies in Fig. 13B mit Pfeilen 46 veranschaulicht ist, wogegen im Biegebereich innen Druckkräfte wirken, die mit Pfeilen 47 in Fig. 13B gezeigt sind. Die neutrale Ebene 48, in der das Dünnschichtsystem 8 bevorzugt angeordnet wird, bleibt bei der Biegung im Wesentlichen kräftefrei, so dass dann, wenn die gesamte Anordnung einer Biegung unterworfen wird, im Dünnschichtbauelement 8 selbst keine Zug- bzw. Druckkräfte auftreten.

In Fig, 14 ist schematisch die Herstellung von Dünnschichtanordnungen mit flexiblen Leiterplatten in einem so genannten Rolle-zu-Rolle-Verfahren gezeigt. Dabei wird ein flexibles, Metall-kaschiertes Basismaterial, wie z.B. eine Polyimidfolie mit Kupferkaschierung, als flexible Leiterplatten-Bahn 2' von einer Startrolle 50 ausgehend einer Prozesskammer oder -station 51 zugeführt, wo eine fotolithografische Strukturierung durchgeführt sowie die Verstärkung 5A der Metallkaschierung 5, d.h. Leiterschicht, wie vorstehend beschrieben angebracht wird.

Über Rollen wird das Bahnmaterial 2' dann einer Prozesskammer bzw. -station 52 zugeführt, wo die Metallkaschierung 5, 5A geglättet bzw. poliert wird. Vor dem Eintritt in diese Prozesskammer 52 kann die flexible Leiterplatten-Bahn 2' rückseitig mit Hilfe einer flexible Trägerfolie 53 versteift werden, die von einer Rolle 54 abgewickelt wird. Nach dem Austritt aus der Prozesskammer 52 kann diese eine vorübergehende Versteifung bildende, flexible Trägerfolie 53 auf einer Rolle 55 aufgewickelt werden. Die Trägerfolie 53 kann aber selbstverständlich auch in einer späteren Stufe des Fertigungsprozesses wieder entfernt werden.

Im Zuge des Glättungs- bzw. Poliervorganges, kann das Bahnmaterial 2' gegebenenfalls auch über einen ebenen Tisch 56 in der Prozesskammer 52 geführt werden, um so eine besonders wirksame Versteifung bzw. Stützung des Bahnmaterials 2' zu erzielen.

Das Bahnmaterial 2' gelangt sodann in einen Prozessbereich oder in eine Prozesskammer 57, wo die polierte Metallkaschierung 5, 5A veredelt (Kontaktschicht 18) und passiviert (Passivierungsschicht 20) wird, wie dies vorstehend im Prinzip beispielsweise anhand der Fig. 4 bis 6 erläutert worden ist.

In einer Prozessstation oder -kammer 58 wird dann die Beschichtung der flexiblen Leiterplatte 2 mit den (aktiven oder passiven) Dünnschichten, z.B. 21, mit der oberen, beispielsweise lichtdurchlässigen Kontaktschicht 22 und mit der das Dünnschichtbauelement abschließenden, gegebenenfalls ebenfalls lichtdurchlässigen Deckelektrode 9 vorgenommen. Die aktiven (oder gegebenenfalls passiven) Dünnschichten können wiederum organische oder anorganische Materialien, wie an sich bekannt, sein.

Schließlich kann die flexible Leiterplatte 2, d.h. das Bahnmaterial 2', in einer Prozessstation 59 mit Verkapselungslagen 10 beschichtet werden, welche bevorzugt als Bahnmaterial von einer Rolle 60 abgerollt, auf die flexible Leiterplatte 2' zugeführt und auflaminiert werden können. Abschließend wird das so erhaltene Bahnmaterial 61, also die flexible Dünnschichtanordnung mit flexibler Leiterplatte und flexibler Verkapselung, auf einer Rolle 62 aufgerollt und für spätere Zuschneid- bzw. Konturierungsschritte bereitgehalten.

Wie bereits vorstehend erwähnt und anhand der Fig. 13A und 13B erläutert, ist es von Vorteil, wenn die Verkapselung 10 so konzipiert wird, dass das Dünnschichtbauelement dann, wenn die Verkapselungslage in der Prozessstation 59 auf die flexible Leiterplatten-Bahn auflaminiert wird, in der neutralen Ebene 48 zu liegen kommt. Dadurch wird beim späteren Biegen des Gesamtsystems das Dünnschichtsystem 8 praktisch keiner mechanischen Beanspruchung unterworfen, so dass Delaminationen und Bruchrisse etc. vermieden werden können.

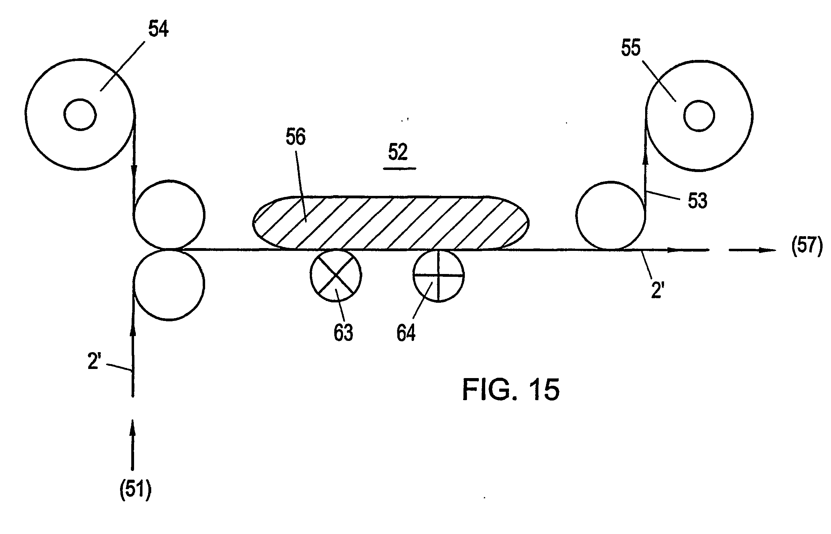

Fig. 15 veranschaulicht den mechanischen Glättungs- und Poliervorgang in der Prozessstation 52 etwas detaillierter, wobei auch schematisch Glättungs- und Polierwalzen oder dergl. 63 bzw. 64 gezeigt sind. Wie erwähnt wird dabei die flexible Leiterplatte 2' auf der Rückseite mit Hilfe einer temporären Trägerfolie 53 versteift, und sie wird überdies eben über einen Poliertisch 56 geführt, der den Glätt- bzw. Läpp- und Polierwalzen oder -scheiben 63, 64 als Unterlage dient. Die Trägerfolie 53 kann wie erwähnt in Anschluss an diesen Glättungsvorgang sofort wieder entfernt werden, sie kann aber auch zu einem späteren Zeitpunkt von der Leiterplatten-Bahn 2' weg geführt werden.

## Patentansprüche

1. Anordnung mit einem Substrat, das durch eine Leiterplatte (2) mit einem Isoliermaterial-Grundkörper (3) und einer Metallkaschierung als Leiterschicht (5) gebildet ist, und mit zumindest einem auf dem Substrat aufgebrachten elektronischen Bauelement, wobei auf dem Substrat eine durch die Leiterschicht gebildete eine Grundelektrode (4) vorliegt, auf der zum Bauelement gehörige Schichten (21) einschließlich einer oberen Deckelektrode (9) angeordnet sind, **dadurch gekennzeichnet, dass** das Bauelement in Dünnschichttechnik aufgebracht ist, dass die Leiterschicht (5) zumindest an der Stelle des Dünnschichtbauelements geglättet ist, wobei die geglättete Leiterschicht (5) über Flächenbereiche der Größe 20 x 20 µm² (Mikrorauigkeit) eine mittlere Oberflächenrauigkeit von maximal 10 nm, vorzugsweise maximal 3 nm, aufweist, und dass zwischen der geglätteten, gegebenenfalls verstärkten Leiterschicht (5) und den darüber liegenden Dünnschichten (21) des Dünnschichtbauelements eine Kontaktschicht (18) in Dünnschichttechnik vorgesehen ist, welche auf der Oberfläche der Grundelektrode (4) physikalisch bzw. chemisch adsorbiert ist.

2. Anordnung nach Anspruch 1, **dadurch gekennzeichnet, dass** in der Leiterplatte (2) Via-Verbindungen zur elektronischen Kontaktierung der Elektroden durch den Grundkörper (3) der Leiterplatte (2) hindurch vorgesehen sind.

3. Anordnung nach Anspruch 1 oder 2, **dadurch gekennzeichnet, dass** in der Leiterplatte (2) eine Durchkontaktierung (6) zur Grundelektrode (4) direkt unter dieser vorgesehen ist.

4. Anordnung nach einem der Ansprüche 1 bis 3, **dadurch gekennzeichnet, dass** auch unter der Deckelektrode (9) eine Kontaktschicht (22) vorgesehen ist.

5. Anordnung nach einem der Ansprüche 1 bis 4, **dadurch gekennzeichnet, dass** die Kontaktschicht (18; 22) zugleich eine Passivierungsschicht für die Elektrode bildet.

6. Anordnung nach einem der Ansprüche 1 bis 5, **dadurch gekennzeichnet, dass** die Kontaktschicht (18; 22) zugleich eine Stabilisierungsschicht für die Haftung zwischen der Elektrode und der benachbarten Dünnschicht bildet.

7. Anordnung nach einem der Ansprüche 1 bis 6, **dadurch gekennzeichnet, dass** die Kontaktschicht (18; 22) eine metallische Schicht, z.B. aus Aluminium, Gold, Palladium, Platin oder eine Metalllegierung, oder Kohlenstoff oder eine halbleitende Verbindung ist.

8. Anordnung nach einem der Ansprüche 1 bis 6, **dadurch gekennzeichnet, dass** die Kontaktschicht (18; 22) durch eine leitfähige Suspension oder Lösung, z.B. auf Basis von Polyanilin, Polyethylen-Dioxithiophen/Polystyrolsulfonsäure, gebildet ist.

9. Anordnung nach einem der Ansprüche 1 bis 8, **dadurch gekennzeichnet, dass** auf von der Leiterschicht (5) freigestellten, freiliegenden Bereichen des Grundkörpers (3) eine, Kontamination des jeweiligen Dünnschichtbauelements durch aus dem Grundkörper (3) austretende Substanzen verhindernde Dünnschicht-Passivierungsschicht (20) aufgebracht ist.

10. Anordnung nach Anspruch 9, **dadurch gekennzeichnet, dass** die Passivierungsschicht (20) aus Siliziumoxid, einem Sol-Gel-System oder einer Epoxidverbindung besteht.

11. Dünnschichtanordnung nach einem der Ansprüche 1 bis 10, **dadurch gekennzeichnet, dass** die Deckelektrode (9), gegebenenfalls auch die darunter vorgesehene Kontaktschicht (22), zumindest transluzent, vorzugsweise transparent ausgebildet ist.

12. Dünnschichtanordnung nach Anspruch 11, **dadurch gekennzeichnet, dass** als Dünnschichtbauelement (26) eine Elektrolumineszenzvorrichtung angeordnet ist.

13. Anordnung nach Anspruch 12, **dadurch gekennzeichnet, dass** lokale Grundelektroden (4), die individuelle Durchkontaktierungen (6) haben, innerhalb einer isolierenden Gitterstruktur auf der Leiterplatte (2) vorliegen und darüber ein flächiges Elektrolumineszenz-Dünnschichtsystem sowie eine flächige oder aber streifen- oder symbolweise strukturierte Deckelektrode (9) angebracht sind.

14. Anordnung nach Anspruch 11, **dadurch gekennzeichnet, dass** als Dünnschichtbauelement eine Leuchtdiode vorgesehen ist.

15. Anordnung nach Anspruch 11, **dadurch gekennzeichnet, dass** als Dünnschichtbauelement eine fotovoltaische Anordnung vorgesehen ist.

16. Anordnung nach einem der Ansprüche 1 bis 11, **dadurch gekennzeichnet, dass** als Dünnschichtbauelement ein Sensor, insbesondere ein optischer Sensor oder ein Temperatursensor, vorgesehen ist.

17. Anordnung nach einem der Ansprüche 1 bis 11, **dadurch gekennzeichnet, dass** als Dünnschichtbauelement eine Diode (30) vorgesehen ist.

18. Anordnung nach einem der Ansprüche 1 bis 11, **dadurch gekennzeichnet, dass** als Dünnschichtbauelement ein Transistor, insbesondere ein Feldeffekttransistor (40), vorgesehen ist.

19. Anordnung nach einem der Ansprüche 1 bis 11, **dadurch gekennzeichnet, dass** als Dünnschichtbauelement ein Überspannungsschutzelement vorgesehen ist.

20. Anordnung nach einem der Ansprüche 1 bis 11, **dadurch gekennzeichnet, dass** als Dünnschichtbauelement ein Widerstand und/oder ein Kondensator vorgesehen ist.

21. Anordnung nach einem der Ansprüche 1 bis 20, **dadurch gekennzeichnet, dass** dem Dünnschichtbauelement eine Verkapselung (10) zugeordnet ist.

22. Anordnung nach Anspruch 21, **dadurch gekennzeichnet, dass** die Verkapselung (10) transluzent oder transparent ausgebildet ist.

23. Anordnung nach Anspruch 21 oder 22, **dadurch gekennzeichnet, dass** innerhalb der Verkapselung (10) ein abgeschlossenes Gasvolumen (11) vorliegt.

24. Anordnung nach Anspruch 22 oder 23, **dadurch gekennzeichnet, dass** die Verkapselung Farbwandler- bzw. Indexanpassungsschichten (12) in Ausrichtung zu den lokalen Grundelektroden trägt.

25. Anordnung nach einem der Ansprüche 1 bis 24, **dadurch gekennzeichnet, dass** die Leiterplatte (2) eine flexible Leiterplatte ist.

26. Anordnung nach Anspruch 25, **dadurch gekennzeichnet, dass** das Dünnschichtbauelement eine flexible Struktur hat.

27. Anordnung nach Anspruch 25 oder 26, soweit abhängig von einem der Ansprüche 21 bis 24, **dadurch gekennzeichnet, dass** die Verkapselung (10) flexibel ist, z.B. aus einem dünnen Glaslaminat oder einem Polymer-Oxid-Verbundschichtsystem besteht.

28. Anordnung nach Anspruch 27, **dadurch gekennzeichnet, dass** die Verkapselung (10) über eine Haftvermittlungsschicht (44) über dem Dünnschichtbauelement (8) angebracht ist.

29. Anordnung nach Anspruch 27 oder 28, **dadurch gekennzeichnet, dass** die Verkapselung (10) über eine als Sperrschicht für Feuchte und Luft dienende Passivierungslage (45) über dem Dünnschichtbauelement (8), gegebenenfalls über der Haftvermittlungsschicht (44), angebracht ist.

30. Anordnung nach einem der Ansprüche 27 bis 29, **dadurch gekennzeichnet, dass** das Dünnschichtbauelement (8) in der neutralen Ebene (48) zwischen der flexiblen Leiterplatte (2) und der flexiblen Verkapselung (10) angebracht ist.

31. Anordnung nach einem der Ansprüche 25 bis 30, **dadurch gekennzeichnet, dass** die flexible Leiterplatte (2) transparent oder transluzent ist.

32. Anordnung nach einem der Ansprüche 25 bis 31, **gekennzeichnet durch** eine Ausbildung als aufrollbares bzw. faltbares Bahnrnaterial (61).

33. Verfahren zum Herstellen einer Anordnung mit wenigstens einem elektronischen Bauelement, das auf einem Substrat aufgebracht wird, das eine Leiterplatte (2) mit einem Isoliermaterial-Grundkörper (3) und einer Metallkaschierung als Leiterschicht (5) aufweist, **dadurch gekennzeichnet, dass** die Leiterschicht (5) zumindest lokal, gegebenenfalls nach Anbringung einer Verstärkung, über Flächenbereiche der Größe 20 x 20 µm² bis zu einer mittleren Oberflächenrauigkeit von maximal 10 nm, vorzugsweise maximal 3 nm, geglättet wird, um zumindest eine Grundelektrode (4) für das Bauelement zu bilden, und dass auf der Grundelektrode (4) eine Kontaktschicht (18) in Dünnschichttechnik angebracht wird, bevor darüber das übrige Bauelement in Dünnschichttechnik angebracht wird.

34. verfahren nach Anspruch 33, **dadurch gekennzeichnet, dass** die Leiterschicht(5) durch ein mechanisches Verfahren, wie z.B. Läppen, Schleifen oder Polieren, geglättet wird.

35. Verfahren nach Anspruch 33, **dadurch gekennzeichnet, dass** die Leiterschicht (5) durch elektrochemisches Polieren geglättet wird.

36. Verfahren nach Anspruch 33, **dadurch gekennzeichnet, dass** die Leiterschicht durch chemisch-mechanisches Polieren geglättet wird.

37. Verfahren nach Anspruch 33, **dadurch gekennzeichnet, dass** die Leiterschicht durch chemisches Ätzen, beispielsweise mit Schwefelsäure, Salpetersäure oder Chromschwefelsäure, geglättet wird.

38. Verfahren nach Anspruch 33, **dadurch gekennzeichnet, dass** die Leiterschicht durch Ionenätzen geglättet wird.

39. Verfahren nach Anspruch 33, **dadurch gekennzeichnet, dass** die Leiterschicht (5) durch Beschuss mit Partikeln einzelner oder mehrerer Atome oder Moleküle, wie z.B. Argon oder Argon-Cluster, geglättet wird.

40. Verfahren nach einem der Ansprüche 3:3 bis 39, **dadurch gekennzeichnet, dass** die Leiterschicht (5) elektrochemisch verstärkt wird.

41. Verfahren nach einem der Ansprüche 33 bis 40, **dadurch gekennzeichnet, dass** die Leiterplatte (5) vor einem lokalen Verstärken der Leiterschicht in den übrigen Bereichen vorübergehend fotolithografisch passiviert wird.

42. Verfahren nach einem der Ansprüche 33 bis 41, **dadurch gekennzeichnet, dass** von der Leiterschicht (5) freigelegte Bereiche des Grundkörpers (3) vor dem Anbringen des übrigen Dünnschichtbauelements fotolithografisch unterstützt in Dünnschichttechnik passiviert wird.

43. Verfahren nach Anspruch 41 oder 42, **dadurch gekennzeichnet, dass** eine Passivierungsschicht (20) durch thermisches Verdampfen aufgebracht wird.

44. Verfahren nach Anspruch 41 oder 42, **dadurch gekennzeichnet, dass** eine Passivierungsschicht (20) durch Kaltkatodenbeschichtung aufgebracht wird.

45. Verfahren nach einem der Ansprüche 33 bis 44, **dadurch gekennzeichnet, dass** als Substrat eine flexible Leiterplatte (2) verwendet wird.

46. Verfahren nach Anspruch 45, **dadurch gekennzeichnet, dass** die flexible Leiterplatte vorübergehend, zumindest während des Glättens, durch eine Versteifungslage (53) und/oder durch Führen über einen Tisch (56) gestützt wird.

47. Verfahren nach Anspruch 45 oder 46, **dadurch gekennzeichnet, dass** eine flexible Leiterplatten-Bahn (2') verwendet wird, die von einer Rolle (50) abgewickelt wird.

48. Verfahren nach einem der Ansprüche 45 bis 47, **dadurch gekennzeichnet, dass** eine vorgefertigte flexible Verkapselungs-Bahn (10) über-der mit dem Dünnschichtbauelement versehenen flexiblen Leiterbahn (2') angebracht wird.

49. Verfahren nach Anspruch 48, **dadurch gekennzeichnet, dass** die Verkapselungs-Bahn (10) von einer Rolle (60) abgewickelt wird.

## Claims

1. An assembly including a substrate, said substrate being comprised of a printed circuit board (2) including an insulation-material base body (3) and a metal lamination as a conductor layer (5), and including at least one electronic component applied on the substrate, wherein a base electrode (4) formed by the conductor layer is provided on the substrate, on which base electrode (4) layers (21) belonging to the component and including an upper cover-electrode (9) are arranged, **characterized in that** the component is applied by thin-film technology, that the conductor layer (5) is smoothed at least on the location of the thin-film component, wherein the smoothed conductor layer (5), over surface areas having the dimensions of 20x20µm² (micro-roughness), exhibits a maximum mean surface roughness of 10nm and, preferably, 3nm, and that a contact layer (18) is applied by thin-film technology between the smoothed, optionally reinforced, conductor layer (5) and the superimposed thin-film layers (21) of the thin-film component, which contact layer is physically or chemically adsorbed on the surface of the base electrode (4) .

2. The assembly according to claim 1, **characterized in that** via-connections are provided in the printed circuit board (2) for the electronic contacting of the electrodes via the base body (3) of the printed circuit board (2).

3. The assembly according to claim 1 or 2, **characterized in that** a feedthrough (6) to the base electrode (4) is provided in the printed circuit board (2) directly below the base electrode (4).

4. The assembly according to any one of claims 1 to 3, **characterized in that** a contact layer (22) is also provided below the counter-electrode (9).

5. The assembly according to any one of claims 1 to 4, **characterized in that** the contact layer (18; 22) also constitutes a passivation layer for the electrode.

6. The assembly according to any one of claims 1 to 5, **characterized in that** the contact layer (18; 22) also constitutes a stabilization layer for the adherence between the electrode and the adjacent thin-film layer.

7. The assembly according to any one of claims 1 to 6, **characterized in that** the contact layer (18; 22) is a metallic layer made, e.g., of aluminum, gold, palladium, platinum or a metal alloy, or carbon, or a semi-conductive compound.

8. The assembly according to any one of claims 1 to 6, **characterized in that** the contact layer (18; 22) is formed by a conductive suspension or solution, e.g., based on polyaniline, polyethylene dioxithiophene/polystyrenesulfonic acid.

9. The assembly according to any one of claims 1 to 8, **characterized in that** a thin-film passivation layer (20) is applied on exposed base body zones uncovered from the conductor layer (5), said passivation layer preventing the contamination of the respective thin-film component by substances emerging from the base body (3).

10. The assembly according to claim 9, **characterized in that** the passivation layer (20) is made of silicon dioxide, a sol-gel system or an epoxy compound.

11. The thin-film assembly according to any one of claims 1 to 10, **characterized in that** the cover-electrode (9) and, optionally, also the contact layer (22) provided therebelow are designed to be at least translucent and, preferably, transparent.

12. The thin-film assembly according to claim 11, **characterized in that** an electroluminescent device is provided as said thin-film component (24).

13. The assembly according to claim 12, **characterized in that** local base electrodes (4) having individual feedthroughs (6) are provided on the printed circuit board (2) within an insulating grid structure, with a planar electroluminescent thin-film system as well as a planar, or strip-wisely or symbol-wisely patterned, cover-electrode (9) being arranged thereabove.

14. The assembly according to claim 11, **characterized in that** a light-emitting diode is provided as said thin-film component.

15. The assembly according to claim 11, **characterized in that** a photovoltaic assembly is provided as said thin-film component.

16. The assembly according to any one of claims 1 to 11, **characterized in that** a sensor and, in particular, an optical sensor or a temperature sensor is provided as said thin-film component.

17. The assembly according to any one of claims 1 to 11, **characterized in that** a diode (30) is provided as said thin-film component.

18. The assembly according to any one of claims 1 to 11, **characterized in that** a transistor and, in particular, a field-effect transistor (40) is provided as said thin-film component.

19. The assembly according to any one of claims 1 to 11, **characterized in that** an overvoltage protection element is provided as said thin-film component.

20. The assembly according to any one of claims 1 to 11, **characterized in that** a resistor and/or a capacitor is provided as said thin-film component.

21. The assembly according to any one of claims 1 to 20, **characterized in that** an encapsulation (10) is associated to said thin-film component.

22. The assembly according to claim 21, **characterized in that** said encapsulation (10) is designed to be translucent or transparent.

23. The assembly according to claim 21 or 22, **characterized in that** an enclosed gas volume (11) is present within said encapsulation (10).

24. The assembly according to claim 22 or 23, **characterized in that** said encapsulation carries color converting and/or index matching layers (12) in alignment with the local base electrodes.

25. The assembly according to any one of claims 1 to 24, **characterized in that** the printed circuit board (2) is a flexible printed circuit board.

26. The assembly according to claim 25, **characterized in that** the thin-film component has a flexible structure.

27. The assembly according to claim 25 or 26 as far as dependent on any one of claims 21 to 24, **characterized in that** said encapsulation (10) is flexible, made, e.g., of a thin glass laminate or a polymer-oxide composite layer system.

28. The assembly according to claim 27, **characterized in that** said encapsulation (10) is provided above the thin-film component (8) via an adhesion-promoting layer (44).

29. The assembly according to claim 27 or 28, **characterized in that** said encapsulation (10), via a passivation layer (45) serving as a barrier layer against moisture and air, is provided above the thin-film component (8), optionally above the adhesion-promoting layer (44).

30. The assembly according to any one of claims 27 to 29, **characterized in that** the thin-film component (8) is provided in the neutral plane (48) between the flexible printed circuit board (2) and the flexible encapsulation (10).

31. The assembly according to any one of claims 25 to 30, **characterized in that** the flexible printed circuit board (2) is transparent or translucent.

32. The assembly according to any one of claims 25 to 31, **characterized by** a configuration as a roll-up or foldable sheet material (61).

33. A method for producing The assembly including at least one electronic component which is applied on a substrate which has a printed circuit board (2) with an insulation-material base body (3) and a metal lamination as a conductor layer (5), **characterized in that** the conductor layer (5) is smoothed at least locally, optionally after attachment of a reinforcement, over surface areas having the dimensions of 20x20µm² to a maximum mean surface roughness of 10nm and, preferably, 3nm, in order to form at least one base electrode (4) for the component, and that a contact layer (18) is applied on the base electrode (4) by thin-film technology prior to attaching the remaining component thereabove by thin-film technology.

34. The method according to claim 33, **characterized in that** the conductor layer (5) is smoothed by a mechanical method such as, e.g., lapping, grinding or polishing.

35. The method according to claim 33, **characterized in that** the conductor layer (5) is smoothed by electrochemical polishing.

36. The method according to claim 33, **characterized in that** the conductor layer is smoothed by chemicomechanical polishing.

37. The method according to claim 33, **characterized in that** the conductor layer is smoothed by chemical etching using, for instance, sulfuric acid, nitric acid or chromosulfuric acid.

38. The method according to claim 33, **characterized in that** the conductor layer is smoothed by ion etching.

39. The method according to claim 33, **characterized in that** the conductor layer (5) is smoothed by bombardment with particles of individual or several atoms or molecules, such as, e.g, argon or argon clusters.

40. The method according to any one of claims 33 to 39, **characterized in that** the conductor layer (5) is electrochemically reinforced.

41. The method according to any one of claims 33 to 40, **characterized in that** the printed circuit board (5) is temporarily passivated by photolitography in the remaining areas prior to locally reinforcing the conductor layer.

42. The method according to any one of claims 33 to 41, **characterized in that** base body areas uncovered from the conductor layer (5) are passivated by photolitographically assisted thin-film technology prior to attaching the remaining thin-film component.

43. The method according to claim 41 or 42, **characterized in that** a passivation layer is applied by thermal evaporation.

44. The method according to claim 41 or 42, **characterized in that** a passivation layer (20) is applied by cold cathode coating.

45. The method according to any one of claims 33 to 44, **characterized in that** a flexible printed circuit board (2) is used as said substrate.

46. The method according to claim 45, **characterized in that** the flexible printed circuit board is temporarily supported, at least during smoothing, by a stiffening layer and/or by being guided over a table.

47. The method according to claim 45 or 46, **characterized in that** a flexible printed circuit board sheet (2') is used which is unwound from a reel (50).

48. The method according to any one of claims 45 to 47, **characterized in that** a prefabricated flexible encapsulation sheet (10) is applied above the flexible printed circuit board sheet (2') provided with the thin-film component.

49. The method according to claim 48, **characterized in that** the encapsulation sheet (10) is unwound from a reel (60).

## Revendications

1. Agencement comprenant un substrat, qui est formé par une plaque de circuit (2) avec un corps de base (3) en matériau isolant et un placage métallique en tant que couche conductrice (5), et comprenant au moins un composant électronique appliqué sur le substrat, agencement dans lequel sur le substrat se trouve une électrode de base (4) qui est formée par la couche conductrice et sur laquelle sont agencées des couches (21) faisant partie du composant, y compris une électrode de couverture (9) supérieure, **caractérisé en ce que** le composant est appliqué selon la technique des couches minces, **en ce que** la couche conductrice (5) est lissée au moins à l'endroit du composant en couches minces, la couche conductrice (5) lissée présentant sur des zones de surface d'une grandeur de 20 x 20 µm² (microrugosité), une rugosité de surface moyenne d'au maximum 10 nm, de préférence au maximum de 3 nm, et **en ce qu'**entre la couche conductrice (5) lissée, le cas échéant renforcée, et les couches minces (21) du composant en couches minces, qui sont situées par-dessus, il est prévu une couche de contact (18) selon une technique des couches minces, qui est adsorbée physiquement ou chimiquement sur la surface de l'électrode de base (4).

2. Agencement selon la revendication 1, **caractérisé en ce que** dans la plaque de circuit (2) sont prévues des liaisons dites via pour assurer le contact de connexion électronique des électrodes à travers le corps de base (3) de la plaque de circuit (2).

3. Agencement selon la revendication 1 ou 2, **caractérisé en ce que** dans la plaque de circuit (2) il est prévu un contact de connexion traversant (6) vers l'électrode de base (4) directement sous celle-ci.

4. Agencement selon l'une des revendications 1 à 3, **caractérisé en ce que** sous l'électrode de couverture (9) est également prévue une couche de contact (22).

5. Agencement selon l'une des revendications 1 à 4, **caractérisé en ce que** la couche de contact (18 ; 22) forme simultanément une couche de passivation pour l'électrode.

6. Agencement selon l'une des revendications 1 à 5, **caractérisé en ce que** la couche de contact (18 ; 22) forme simultanément une couche de stabilisation pour l'adhérence entre l'électrode et la couche mince voisine.

7. Agencement selon l'une des revendications 1 à 6, **caractérisé en ce que** la couche de contact (18 ; 22) est une couche métallique, par exemple de l'aluminium, de l'or, du palladium, du platine, ou un alliage métallique, ou du carbone ou un composé semi-conducteur.

8. Agencement selon l'une des revendications 1 à 6, **caractérisé en ce que** la couche de contact (18 ; 22) est formée par une suspension ou solution conductrice, par exemple à base de polyaniline, polyéthylènedioxythiophène/acide poly(styrène sulfonate).

9. Agencement selon l'une des revendications 1 à 8, **caractérisé en ce que** sur les zones du corps de base (3) dégagées, ayant été débarrassées de la couche conductrice (5), est appliquée une couche de passivation (20) en couche mince empêchant une contamination du composant à couches minces considéré par des substances s'échappant du corps de base (3).

10. Agencement selon la revendication 9, **caractérisé en ce que** la couche de passivation (20) est réalisée en oxyde de silicium, par un système sol-gel ou un composé époxyde.

11. Agencement à couches minces selon l'une des revendications 1 à 10, **caractérisé en ce que** l'électrode de couverture (9), le cas échéant également la couche de contact (22) prévue en-dessous, est ou sont au moins translucides, de préférence transparentes.

12. Agencement à couches minces selon la revendication 11, **caractérisé en ce qu'**en guise de composant en couches minces (26) est agencé un système à électroluminescence.

13. Agencement selon la revendication 12, **caractérisé en ce que** des électrodes de base (4) locales, qui possèdent des contacts de connexion traversants (6), sont prévues sur la plaque de circuit (2) à l'intérieur d'une structure en treillis isolante, et par-dessus sont rapportés un système à électroluminescence en couches minces de surface, ainsi qu'une électrode de couverture (9) de surface ou structurée en forme de bandes ou de symboles.

14. Agencement selon la revendication 11, **caractérisé en ce qu'**il est prévu une diode luminescente en guise de composant en couches minces.

15. Agencement selon la revendication 11, **caractérisé en ce qu'**il est prévu un agencement photovoltaïque en guise de composant en couches minces.

16. Agencement selon l'une des revendications 1 à 11, **caractérisé en ce qu'**il est prévu en guise de composant en couches minces, un détecteur, notamment un détecteur optique ou un détecteur de température.

17. Agencement selon l'une des revendications 1 à 11, **caractérisé en ce qu'**il est prévu en guise de composant en couches minces, une diode (30).

18. Agencement selon l'une des revendications 1 à 11, **caractérisé en ce qu'**il est prévu en guise de composant en couches minces, un transistor, notamment un transistor à effet de champ (40).

19. Agencement selon l'une des revendications 1 à 11, **caractérisé en ce qu'**il est prévu en guise de composant en couches minces, un élément de protection contre les surtensions.

20. Agencement selon l'une des revendications 1 à 11, **caractérisé en ce qu'**il est prévu en guise de composant en couches minces, une résistance et/ou un condensateur.

21. Agencement selon l'une des revendications 1 à 20, **caractérisé en ce qu'**une encapsulation (10) est associée au composant en couches minces.

22. Agencement selon la revendication 21, **caractérisé en ce que** l'encapsulation (10) est translucide ou transparente.

23. Agencement selon la revendication 21 ou 22, **caractérisé en ce qu'**un volume de gaz (11) enfermé est présent à l'intérieur de l'encapsulation (10).

24. Agencement selon la revendication 22 ou 23, **caractérisé en ce que** l'encapsulation porte des couches de conversion chromatique ou d'adaptation d'index (12) orientées en direction des électrodes de base locales.

25. Agencement selon l'une des revendications 1 à 24, **caractérisé en ce que** la plaque de circuit (2) est une plaque de circuit flexible.

26. Agencement selon la revendication 25, **caractérisé en ce que** le composant en couches minces présente une structure flexible.

27. Agencement selon la revendication 25 ou 26, dans cette mesure dépendant de l'une des revendications 21 à 24, **caractérisé en ce que** l'encapsulation (10) est flexible, en étant par exemple réalisée en un mince stratifié de verre ou en un système de couches composites oxydes-polymères.

28. Agencement selon la revendication 27, **caractérisé en ce que** l'encapsulation (10) est appliquée par-dessus le composant en couches minces (8) par l'intermédiaire d'une couche d'agent de pontage ou d'agent adhésif (44).

29. Agencement selon la revendication 27 ou 28, **caractérisé en ce que** l'encapsulation (10) est appliquée par-dessus le composant en couches minces (8), le cas échéant par-dessus la couche d'agent de pontage (44), par l'intermédiaire d'une couche de passivation (45) servant de couche de barrage pour l'humidité et l'air.

30. Agencement selon l'une des revendications 27 à 29, **caractérisé en ce que** le composant en couches minces (8) est appliqué dans le plan neutre (48) entre la plaque de circuit (2) flexible et l'encapsulation (10) flexible.

31. Agencement selon l'une des revendications 25 à 30, **caractérisé en ce que** la plaque de circuit (2) flexible est transparente ou translucide.

32. Agencement selon l'une des revendications 25 à 31, **caractérisé par** une réalisation sous la forme d'un matériau en nappe ou en bande (61) pouvant être enroulé ou plié.

33. Procédé pour la fabrication d'un agencement comprenant au moins un composant électronique, qui est appliqué sur un substrat comportant une plaque de circuit (2) avec un corps de base (3) en matériau isolant et un placage métallique en tant que couche conductrice (5), **caractérisé en ce que** la couche conductrice (5) est lissée, au moins localement, le cas échéant après application d'un renfort, sur des zones de surface d'une grandeur de 20 x 20 µm² jusqu'à une valeur de rugosité de surface moyenne d'au maximum 10 nm, de préférence au maximum de 3 nm, pour former au moins une électrode de base (4) pour le composant, et **en ce que** sur l'électrode de base (4) est appliquée une couche de contact (18) selon la technique des couches minces, avant l'application du reste du composant selon la technique des couches minces.

34. Procédé selon la revendication 33, **caractérisé en ce que** la couche conductrice (5) est lissée par un procédé mécanique, comme par exemple le rodage, la rectification ou le polissage.

35. Procédé selon la revendication 33, **caractérisé en ce que** la couche conductrice (5) est lissée par polissage électrochimique.

36. Procédé selon la revendication 33, **caractérisé en ce que** la couche conductrice est lissée par polissage mécanique-chimique.

37. Procédé selon la revendication 33, **caractérisé en ce que** la couche conductrice est lissée par attaque chimique, par exemple avec de l'acide sulfurique, de l'acide nitrique ou de l'acide sulfochromique.

38. Procédé selon la revendication 33, **caractérisé en ce que** la couche conductrice est lissée par attaque ionique.

39. Procédé selon la revendication 33, **caractérisé en ce que** la couche conductrice (5) est lissée par bombardement avec des particules d'atomes ou de molécules individuels ou multiples, comme par exemple de l'argon ou des clusters ou agrégats d'argon.

40. Procédé selon l'une des revendications 33 à 39, **caractérisé en ce que** la couche conductrice (5) est renforcée par voie électrochimique.

41. Procédé selon l'une des revendications 33 à 40, **caractérisé en ce que** la plaque de circuit (5), avant un renforcement local de la couche conductrice, est passivée provisoirement dans les zones restantes par photolithographie.

42. Procédé selon l'une des revendications 33 à 41, **caractérisé en ce que** des zones du corps de base (3) dégagées de la couche conductrice (5) sont passivées par la technique des couches minces avec assistance par photolithographie, avant l'application du restant du composant en couches minces.

43. Procédé selon la revendication 41 ou 42, **caractérisé en ce qu'**une couche de passivation (20) est appliquée par évaporation thermique.

44. Procédé selon la revendication 41 ou 42, **caractérisé en ce qu'**une couche de passivation (20) est appliquée par revêtement cathodique à froid.

45. Procédé selon l'une des revendications 33 à 44, **caractérisé en ce que** l'on utilise une plaque de circuit (2) flexible en guise de substrat.

46. Procédé selon la revendication 45, **caractérisé en ce que** la plaque de circuit flexible est soutenue provisoirement, au moins pendant le lissage, par une couche de renfort ou de rigidification (53) et/ou en étant guidée par-dessus une table (56).

47. Procédé selon la revendication 45 ou 46, **caractérisé en ce que** l'on utilise une bande de plaque de circuit flexible (2'), qui est déroulée à partir d'une bobine (50).

48. Procédé selon l'une des revendications 45 à 47, **caractérisé en ce qu'**une bande d'encapsulation (10) flexible et préfabriquée est appliquée par-dessus la bande de plaque de circuit flexible (2') pourvue du composant en couches minces.

49. Procédé selon la revendication 48, **caractérisé en ce que** la bande d'encapsulation (10) est déroulée à partir d'une bobine (60).
